(19) Europäisches Patentamt
European Patent Office
Office européen des brevets

(11) EP 2 386 532 B1

(12) EUROPEAN PATENT SPECIFICATION

(45) Date of publication and mention of the grant of the patent:
**29.03.2017 Bulletin 2017/13**

(21) Application number: **10250942.9**

(22) Date of filing: **18.05.2010**

(51) Int Cl.:
***C04B 35/584*** *(2006.01)* ***C04B 35/593*** *(2006.01)*
***C04B 35/597*** *(2006.01)* ***G01R 3/00*** *(2006.01)*
***G01R 31/28*** *(2006.01)*

(54) **Silicon nitride-melilite composite sintered body and substrate, member, device, and probe card utilizing the same**

Gesinterter Siliciumnitrid-Melilit-Verbundstoffkörper und Substrat, Element, Vorrichtung und Prüfkarte damit

Corps fritté composite à base de nitrure de silicium-mélilite et substrat, élément, dispositif et carte de sonde l'utilisant

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **14.05.2010 JP 2010112131**

(43) Date of publication of application:
**16.11.2011 Bulletin 2011/46**

(73) Proprietor: **NGK Spark Plug Co., Ltd.**
**Nagoya-shi,**
**Aichi 467-8525 (JP)**

(72) Inventors:
- **Hara, Yasushi**
  **Nagoya-shi,**
  **Aichi 467-8525 (JP)**
- **Maeda, Tetsuya**
  **Nagoya-shi,**
  **Aichi 467-8525 (JP)**
- **Tosa, Akifumi**
  **Nagoya-shi,**
  **Aichi 467-8525 (JP)**
- **Sawamura, Takenori**
  **Nagoya-shi,**
  **Aichi 467-8525 (JP)**

(74) Representative: **Nicholls, Michael John**
**J A Kemp**
**14 South Square**
**Gray's Inn**
**London WC1R 5JJ (GB)**

(56) References cited:
**EP-A1- 2 546 216** **JP-A- 2002 128 567**
**JP-A- 2002 257 853** **US-A- 5 114 888**
**US-A1- 2010 130 345** **US-B1- 6 294 244**

- **DATABASE WPI Week 198634 Thomson Scientific, London, GB; AN 1986-223100 XP002682387, & JP 61 155262 A (KYOCERA CORP) 14 July 1986 (1986-07-14) -& JP 6 027029 B (KYOCERA CORP) 13 April 1994 (1994-04-13)**
- **DATABASE WPI Week 200123 Thomson Scientific, London, GB; AN 2001-220977 XP002682388, & JP 2001 019556 A (DENKI KAGAKU KOGYO KK) 23 January 2001 (2001-01-23)**
- **DATABASE WPI Week 201002 Thomson Scientific, London, GB; AN 2009-S58677 -& JP 2009 298688 A (DOKURITSU GYOSEI HOJIN SANGYO GIJUTSU SO) 24 December 2009 (2009-12-24)**

EP 2 386 532 B1

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a silicon nitride-melilite composite sintered body, as well as to a substrate composed of the silicon nitride-melilite composite sintered body, a member composed of the silicon nitride-melilite composite sintered body, a device including a member composed of the silicon nitride-melilite composite sintered body, and a probe card including a member composed of the silicon nitride-melilite composite sintered body.

In the process of manufacturing semiconductor chips, a semiconductor inspection device, for example, a probe card, is generally used to check for the normal operations of an integrated circuit formed on each silicon wafer or semiconductor wafer. The probe card typically has a large number of needle-like probe terminals provided on a lower face of a ceramic substrate made of, for example, alumina. The probe terminals are brought into contact with terminal pads of the semiconductor wafer. The semiconductor wafer is checked for conduction of the integrated circuit and insulation between respective circuits by application of electric current.

The inspection of the operating conditions of the integrated circuit formed on the semiconductor wafer may be required not only at room temperature but in a high temperature condition of not lower than 100°C (for example, 150°C). In the latter case, the probe card is required to quickly increase its temperature with a temperature increase of the semiconductor wafer and have a practically equivalent behavior of thermal expansion to that of the semiconductor wafer. The different behaviors of thermal expansion may cause poor contact of the probe terminals of the probe card with the terminal pads of the semiconductor wafer. There is accordingly a high demand for a probe card having a practically equivalent thermal expansion coefficient to that of the semiconductor wafer and a ceramic material used to manufacture such a probe card. The desired ceramic material accordingly has a sufficiently high mechanical strength and an average thermal expansion coefficient that is arbitrarily adjustable in a range of 2 to 6 ppm/K or more preferably in a range of 3 to 5 ppm/K according to the demand characteristics of the device in a temperature range from room temperature (23°C) to 150°C.

One proposed probe card utilizes a ceramic substrate made of a non-oxide ceramic material, such as aluminum nitride or silicon nitride, to allow for inspection of integrated circuits in the high temperature condition. This probe card has excellent thermal conductivity but only a substantially fixed average thermal expansion coefficient (23°C to 150°C). For example, in the case of application of aluminum nitride as the ceramic material, the average thermal expansion coefficient of the probe card is approximately 4 ppm/K, which is relatively close to the average thermal expansion coefficient of the semiconductor wafer but is not adjustable to another arbitrary value. Namely this proposed technique does not fulfill the recent high demand for the probe card. In the case of application of silicon nitride as the ceramic material the average thermal expansion coefficient of the probe card is undesirably low as 2 ppm/K or below. Alumina widely used as an oxide ceramic material of the ceramic substrate, on the other hand, has an undesirably high average thermal expansion coefficient (23°C to 150°C) of about 6 ppm/K or above.

The ceramic material having the sufficiently high mechanical strength and the average thermal expansion coefficient that is arbitrarily adjustable in the range of 2 to 6 ppm/K in the temperature range from room temperature (23°C) to 150°C would be demanded for the probe card or another equivalent device used for inspection of semiconductor wafers.

The ceramic material having the sufficiently high mechanical strength and the average thermal expansion coefficient that is arbitrarily adjustable in the above range would also be demanded for various substrates and boards, for example, circuit boards with various parts, such as an electronic part and a stiffener, mounted and arranged thereon and heater substrates.

One proposed example of the silicon nitride-based ceramic material has a thermal expansion coefficient in a range of 3.5 to 4.1 ppm/K, which practically satisfies the above condition of the average thermal expansion coefficient in the range of 2 to 6 ppm/K. This silicon nitride-based ceramic material, however, does not have a sufficiently high Young's modulus, which is required for large-size ceramic substrates (having a diameter of not smaller than 30 cm or even a diameter of not smaller than 45 cm). The silicon nitride-based ceramic material also has difficulty in preventing the occurrence of warpage in the cause of sintering relatively thin, large-size ceramic materials having a thickness of not greater than 1 cm and a diameter of not smaller than 30 cm or even a diameter of not smaller than 45 cm.

US-B1-6,294,244 discloses a wiring board equipped with an insulation board formed of a sintered product of silicon nitride containing a rare earth element (RE) and magnesium in a total amount of from 4 to 30 mol % calculated as oxides and at a mol ration ($RE_2O_3$/MgO) calculated as oxides of from 0.1 to 15. This is intended to improve the heat conductivity and heat radiation properties while maintaining strength by reduction of the glass phase in the sintered product. JP-2002-128567 discloses a silicon nitride sintered compact containing melilite in order to prevent oxidation at low temperatures while maintaining excellent mechanical properties. US-A-5,114,888 discloses a silicon nitride sintered body containing at least one rare earth element as oxide and at least one group VIa element as oxide to provide high strength and high oxidation resistance for use as a high temperature structural material. JP-6-27029 discloses a silicon nitride sintered body including an oxide of at least one group III A element and tungsten or a tungsten compound other than tungsten carbide so that grain boundary structures mainly contain crystalline and partially glassy structures to give high oxidation resistance and mechanical strength at high temperatures. JP-A-2009-298688 discloses a sintered compact for an electronic circuit board comprising: crystalline $Si_3N_4$ as main phase; an alkaline-earth metal element compound (AE) in 0.06 to 1.0 wt% by oxide conversion (AEO); a group 3a element compound (RE) in 2.5 to 20 wt% by oxide conversion ($RE_2O_3$); in which the grain-boundary phase consists mainly of a crystalline RE-Si-O-N compound of formula $RE_2Si_3N_4O_3$ (i.e. melilite); and where AE = Mg, Ca, Sr, or Ba, and RE = Yb, Y, Dy, Er, Tm, Lu or Sc.

As a result of the intensive studies and researches for development of a ceramic material satisfying the diverse conditions mentioned above, the inventors of the present invention have found that composing silicon nitride and a melilite at a specific composition gives a composite sintered body having a high mechanical strength, a high Young's modulus, and excellent sinterability or production stability, as well as an average thermal expansion coefficient arbitrarily adjustable to the above range of 2 to 6 ppm/K in the temperature range from room temperature (23°C) to 150°C.

The inventors of the present invention have also found that compounding silicon nitride and a melilite at a specific composition gives a relatively thin, large-size ceramic material (having a thickness of not greater than 1 cm and a diameter of not smaller than 30 cm or even a diameter of not smaller than 45 cm) with the excellent controllability of thermal expansion coefficient and a low warpage (or a high potential for flatness).

By taking advantage of the findings explained above, a silicon nitride-melilite composite sintered body would be provided to have a high mechanical strength, a high Young's modulus, and excellent sinterability, as well as an average thermal expansion coefficient arbitrarily adjustable in a range of 2 to 6 ppm/K or more specifically in a range of 3 to 5 ppm/K at temperatures of 23°C to 150°C. The silicon nitride-melilite composite sintered body would be usable as a primary material of a substrate or a member that is included in, for example, a probe card, a device for inspection of semiconductor, and a device for production of semiconductor.

In order to solve at least part of the problems discussed above and accomplish at least part of the demands discussed above, the present invention is accomplished by any of various aspects and applications discussed below.

According to a first aspect of the invention is directed to a silicon nitride-melilite composite sintered body as defined in Claim 1.

The silicon nitride-melilite composite sintered body according to the first aspect of the invention has an arbitrarily adjustable average thermal expansion coefficient by composing the silicon nitride crystalline phases with a relatively low average thermal expansion coefficient (about 2 ppm/K or below) at temperatures of 23°C to 150°C and the melilite crystalline phases with a relatively high average thermal expansion coefficient (about 5.5 ppm/K or above) at the temperatures of 23°C to 150°C. The ratio of the melilite crystalline phases, which have a higher Young's modulus than that of glass phases, is set to be not less than 20 area% on the cross section of the silicon nitride-melilite composite sintered body. This assures the sufficiently high Young's modulus of the silicon nitride-melilite composite sintered body. The glass phases are a non-crystallized but vitrified portion of the grain boundary phases. The adjustment of the average thermal expansion coefficient by the contents of the silicon nitride crystalline phases and the melilite crystalline phases gives a composite sintered body with a sufficiently high Young's modulus, compared with a sintered body having an average thermal expansion coefficient adjusted by the content of oxide glass phases having the lower Young's modulus than those of the silicon nitride crystalline phases and the melilite crystalline phases.

The silicon nitride-melilite composite sintered body according to the first aspect of the invention has the high mechanical strength, the high Young's modulus, and the excellent sinterability, as well as the average thermal expansion coefficient in the range of 2 to 6 ppm/K at the temperatures of 23°C to 150°C. The silicon nitride-melilite composite sintered body has various applications, such as a probe card use for inspection of semiconductor wafers.

The silicon nitride-melilite composite sintered body according to the first aspect of the invention is usable as a primary material of a substrate having the excellent controllability of thermal expansion coefficient and a low warpage (or a high potential for flatness), and as a primary material of a member included in a device for inspection of semiconductor with high reliability or in a device for production of semiconductor with high reliability.

A second aspect of the invention is directed to a substrate includes the silicon nitride-melilite composite sintered body according to the first aspect of the invention discussed above.

Here the terminology 'substrate' means an unpopulated board used for mounting various parts, such as an electronic part, a stiffener, and a heater, thereon. The substrate according to the second aspect of the invention has the excellent controllability of thermal expansion coefficient and the low warpage (or the high potential for flatness). The substrate composed of the silicon nitride-melilite composite sintered body has various applications including a probe card, a substrate of a heater, a circuit board, a dummy wafer, a vacuum chuck, and other chuck parts.

According to a third aspect of the invention is directed to a member attached to a circuit board with an electronic part mounted thereon. The member includes the silicon nitride-melilite composite sintered body according to the first aspect of the invention discussed above.

The member according to the third aspect of the invention has the excellent controllability of thermal expansion coefficient and the low warpage (or the high potential for flatness). The member composed of the silicon nitride-melilite composite sintered body has various applications including a stiffener or a cap attached to a circuit board.

According to a fourth aspect of the invention is directed to a device used for inspection of semiconductor. The device has a member. The member includes the silicon nitride-melilite composite sintered body according to the first aspect of the invention discussed above.

The device according to the fourth aspect of the invention allows for highly reliable inspection of a target semiconductor sample having an average thermal expansion coefficient in a range of 2 to 6 ppm/K at temperatures of 23°C to 150°C.

According to a fifth aspect of the invention is directed to a device used for production of semiconductor. The device has a member. The member includes the silicon nitride-melilite composite sintered body according to the first aspect of the invention discussed above.

The device according to the fifth aspect of the invention allows for highly reliable production of semiconductor.

According to a sixth aspect of the invention is directed to a probe card. The probe card has a member. The member includes the silicon nitride-melilite composite sintered body according to the first aspect of the invention discussed above.

The probe card according to the sixth aspect of the invention allows for highly reliable inspection of a target semiconductor sample having an average thermal expansion coefficient in a range of 2 to 6 ppm/K at temperatures of 23°C to 150°C.

Fig. 1A is an electron micrograph by SEM imaging of one example of a silicon nitride-melilite composite sintered body in accordance with the invention;
Fig. 1B is diagrammatic reproduction of the electron micrograph shown in Fig. 1A;
Fig. 2 is a diagrammatic sectional-view representation of one example of a probe card utilizing the silicon nitride-melilite composite sintered body in accordance with the invention;
Fig. 3 is a diagrammatic sectional-view representation of another example of the probe card utilizing the silicon nitride-melilite composite sintered body in accordance with the invention;
Fig. 4 is a diagrammatic sectional-view representation of still another example of the probe card utilizing the silicon nitride-melilite composite sintered body in accordance with the invention;
Fig. 5 is a diagrammatic sectional-view representation of one example of a circuit board utilizing the silicon nitride-melilite composite sintered body in accordance with the invention;
Fig. 6 is a diagrammatic sectional-view representation of another example of the circuit board utilizing the silicon nitride-melilite composite sintered body in accordance with the invention;
Fig. 7 is a diagrammatic perspective-view representation of one example of a heater substrate utilizing the silicon nitride-melilite composite sintered body in accordance with the invention;
Fig. 8 is a diagrammatic sectional-view representation of another example of the circuit board utilizing the silicon nitride-melilite composite sintered body in accordance with the invention;
Fig. 9 is a diagrammatic sectional-view representation of still another example of the circuit board utilizing the silicon nitride-melilite composite sintered body in accordance with the invention;
Fig. 10 is a graph of an X-ray diffraction chart of melilite and β silicon nitride;
Fig. 11 is a graph of melilite main peak intensity ratios of melilite crystalline phases plotted against the sintering temperature with regard to composite sintered bodies of Working Examples 65 to 67 sintered at temperatures of 1700°C to 1800°C;
Fig. 12 is a graph of melilite main peak intensity ratios of melilite crystalline phases plotted against the sintering temperature with regard to composite sintered bodies of Working Examples 58 to 60 sintered at the temperatures of 1700°C to 1800°C; and
Figs. 13A through 13D are electron micrographs by SEM imaging of other examples of the silicon nitride-melilite composite sintered body in accordance with the invention.

Some modes of carrying out the invention are described below as preferred embodiments with reference to the accompanied drawings.

A silicon nitride-melilite composite sintered body according to one embodiment of the present invention (hereafter referred to as 'the embodiment') includes silicon nitride crystalline phases, melilite crystalline phases of $Me_2Si_3O_3N_4$, and grain boundary phases. Here Me denotes a metal element combining with silicon nitride to generate a melilite. The melilite crystalline phases have a crystalline structure substantially equivalent to the crystalline structure of $Y_2Si_3O_3N_4$. Strictly speaking, the melilite crystalline phases may have the ratio Y:Si:O:N that is slightly deviated from a ratio 2:3:3:4 and may further contain one or multiple additives incorporated in the crystalline structure.

In the silicon nitride-melilite composite sintered body of the embodiment, a ratio of the melilite crystalline phases is not less than 20 area % (or are percent) a cross section of the composite sintered body. The ratio of the melilite crystalline phases to the total of the silicon nitride crystalline phases and the melilite crystalline phases on the cross section of the silicon nitride-melilite composite sintered body is in a range of 25 to 98 area%, preferably in a range of 35 to 98 area%, more preferably in a range of 45 to 98 area%, or most preferably in a range of 50 to 98 area%. In the silicon nitride-melilite composite sintered body of the embodiment, a water absorption rate is not higher than 1.5%, and a sum of the ratio of the melilite crystalline phases and a ratio of the silicon nitride crystalline phases is not less than 80 area% on the cross section of the composite sintered body.

The method of measuring and converting the contents of Si and Me in the embodiment dissolves the silicon nitride-melilite composite sintered body, measures the ratios of the respective elements other than O (oxygen) and N (nitrogen) by ICP (Inductively Coupled Plasma), and converts the Si ratio into $Si_3N_4$ equivalent and the non-Si fractions into oxide equivalents (for example, $Y_2O_3$, SrO, and $Al_2O_3$) to calculate the content ratios of the respective elements relative to the total content of 100 mol%. In conversion of the content of Si into $Si_3N_4$ equivalent and the content of Me into oxide equivalent, the molar ratio of Me in oxide equivalent relative to 100 mol% of Si in $Si_3N_4$ equivalent is in a range of 15 to 100 mol%, preferably in a range of 21 to 100 mol%, more preferably in a range of 30 to 100 mol%, or most preferably in a range of 35 to 100 mol%. In general, addition of a sintering additive for sintering at ordinary pressure allows for densification of the resulting sintered body. An excess of the sintering additive, however, increases the ratio of the glass phase and thereby lowers the Young's modulus and the corrosion resistance. In the silicon nitride-melilite composite sintered body of the embodiment, increasing the content of Me oxide relative to the content of $Si_3N_4$ accelerates densification even in the condition of a small amount of the sintering additive. Namely the Young's modulus and the corrosion resistance are not significantly lowered with a decrease in amount of the sintering additive.

Typical examples of the metal element Me combining with silicon nitride to generate the melilite are group 3 elements Y (yttrium), Sc (scandium), La (lanthanum), Ce (cerium), Pr (praseodymium), Nd (neodymium), Pm (promethium), Sm (samarium), Eu (europium), Gd (gadolinium), Tb (terbium), Dy (dysprosium), Ho (holmium), Er (erbium), Tm (thulium), Yb (ytterbium), Lu (lutetium), Ac (actinium), Th (thorium), Pa (protactinium), U (uranium), Np (neptunium), Pu (plutonium), Am (americium), Cm (curium), Bk (berkelium), Cf (californium), Es (einsteinium), Fm (fermium), Md (mendelevium), No (nobelium), and Lr (lawrencium). From the standpoints of the material cost and the productivity of the melilite, among these group 3 elements, Y, Nd, Sm, Gd, Dy, Er, and Yb are especially preferable, and Y is most preferable.

When the content of Si is less than the above range in $Si_3N_4$ equivalent, the resulting silicon nitride-melilite composite sintered body has the undesirably high average thermal expansion coefficient (23°C to 150°C) that is similar to the average thermal expansion coefficient of alumina. When the content of Si is greater than the above range in $Si_3N_4$ equivalent, on the other hand, generation of the melilite is interfered or prevented and the resulting silicon nitride-melilite composite sintered body has the undesirably low average thermal expansion coefficient (23°C to 150°C) that is similar to the thermal expansion coefficient of silicon nitride. When the content of the metal element Me combining with silicon nitrite to generate the melilite is less than the above range in oxide equivalent, generation of the melilite is interfered or prevented and the resulting silicon nitride-melilite composite sintered body has the undesirably low average thermal expansion coefficient (23°C to 150°C) that is not significantly different from the thermal expansion coefficient of silicon nitride. When the content of the metal element Me is greater than the above range in oxide equivalent, on the other hand, the resulting silicon nitride-melilite composite sintered body has the undesirably high average thermal expansion coefficient (23°C to 150°C) that is not significantly different from the thermal expansion coefficient of alumina. When the content of one or multiple additives is greater than the above range in oxide equivalent, the resulting silicon nitride-melilite composite sintered body has the undesirably lowered mechanical strength or lowered Young's modulus.

The complex compounds of $Me_2O_3$ and $Si_3N_4$ include not only the melilite $Me_2Si_3O_3N_4$ as a 1:1 compound of $Me_2O_3$ and $Si_3N_4$ but $Me_2O_3 \cdot 2Si_3N_4$ as a 1:2 compound of $Me_2O_3$ and $Si_3N_4$, $Me_2O_3 \cdot 3Si_3N_4$ as a 1:3 compound of $Me_2O_3$ and $Si_3N_4$, and $2Me_2O_3 \cdot 3Si_3N_4$ as a 2:3 compound of $Me_2O_3$ and $Si_3N_4$. The silicon nitride-melilite composite sintered body of the embodiment may contain any of these complex compounds.

The additive used in the present invention is at least one element selected among group 2 elements, La, Ce, and Pr. In the case of (A) using at least one element selected among group 2 elements including Be (beryllium), Mg (magnesium), Ca (calcium), Sr (strontium), Ba (barium), and Ra (radium) as the additive, the resulting silicon nitride-melilite composite sintered body preferably contains Si in a range of 41 to 79 mol% or preferably in a range of 46 to 78 mol% in $Si_3N_4$ equivalent, Me in a range of 13 to 46 mol% or preferably in a range of 13 to 43 mol% in oxide equivalent, and the group 2 element in a range of 5 to 20 mol% or preferably in a range of 7 to 16 mol% in oxide equivalent. The content of the group 2 element of not lower than 5 mol% allows for sintering under ordinary pressure, as well as sintering under a pressurized condition, such as gas pressure, HIP (hot isostatic pressing), and hot pressing. The content of the group 2 element of higher than 20 mol% tends to lower the mechanical strength and the Young's modulus. In the case of (B) using at least one element selected among La, Ce, and Pr as the additive, the resulting silicon nitride-melilite composite sintered body preferably contains Si in a range of 45 to 83 mol% or preferably in a range of 46 to 78 mol% in $Si_3N_4$ equivalent, Me in a range of 15 to 49 mol% or preferably in a range of 13 to 43 mol% in oxide equivalent, and the at least one element selected among La, Ce, and Pr in a range of 0.3 to 12 mol% or preferably in a range of 1 to 9 mol% in oxide equivalent. The content of the selected element of not lower than 0.3 mol% allows for sintering under ordinary pressure, as well as sintering under a pressurized condition, such as gas pressure, HIP, and hot pressing. The content of the selected element of higher than 12 mol% tends to lower the mechanical strength or the Young's modulus or increase the average thermal expansion coefficient (23°C to 150°C) to or over 6 ppm/K.

The sintering additive is added for the purpose of accelerating densification. Unlike the simple silicon nitride sintered body, however, the composite sintered body of the embodiment has a large content of melilite having a substantially unknown effect on densification. The content of melilite exceeds the content of silicon nitride in a characteristic area having a high thermal expansion property. The silicon nitride-melilite composite sintered body is obtained as a composite system of multiple different materials. The silicon nitride and the melilite are expected to have different behaviors of densification. The type and the amount of the sintering additive suitable for densification of the compound sintered body are unpredictable. The effect of the conventionally known sintering additive for silicon nitride sintered body on the silicon nitride-melilite composite sintered body of the embodiment is thus unpredictable. Development of a sintering additive suitable for the silicon nitride-melilite composite sintered body would thus be demanded.

In the case of (A), in order to further enhance and stabilize the sinterability, the additive is preferably at least one element selected among Mg, Ca, and Sr. Especially preferable is Sr.

Another selected element but those mentioned above is added as another additive to the silicon nitride-melilite composite sintered body of the embodiment. This additive is Al (aluminum). Addition of this element ensures the more stable sinterability. Addition of a transition metal, such as W (tungsten) or Mo (molybdenum), blackens the resulting composite sintered body and thus effectively reduces the potential for uneven color of the resulting composite sintered body. In order to achieve the above effect, the content of Al is in a range of 2.0 to 10 mol%, more preferably in a range of 2 to 9 mol%, or most preferably in a range of 2 to 4 mol% in oxide equivalent. The optimum range is below 5 mol%. The content of A1 of higher than 10 mol% in oxide equivalent, however, increases the ratio of the other phases but the silicon nitride crystalline phases and the melilite crystalline phases and thereby undesirably lowers the Young's modulus.

Fig. 1 A is an electron micrograph at a 5000-fold magnification by SEM imaging of a mirror-like finished and etched cross section of a silicon nitride-melilite composite sintered body in accordance with the embodiment (a composite sintered body of Working Example 31 discussed later). Fig. 1B is a schematic reproduction view of the electron micrograph of Fig. 1A.

As shown in Figs. 1A and 1B, the typical silicon nitride-melilite composite sintered body in accordance with the embodiment includes silicon nitride crystalline phases 11, melilite crystalline phases 13, and grain boundary phases 15. The grain boundary phases 15 are present in the form of glass phases and/or other crystalline phases but the silicon nitride crystalline phases and the melilite crystalline phases.

In the embodiment of the invention, the preferable area ratios on a cross section of the silicon nitride-melilite composite sintered body are 2 to 70 area% of the silicon nitride crystalline phases, 20 to 97 area% of the melilite crystalline phases, and 1 to 20 area% of the glass phases and the other crystalline phases but the silicon nitride crystalline phases and the melilite crystalline phases. The preferable area ratio of the glass phases and the other crystalline phases but the silicon nitride crystalline phases and the melilite crystalline phases in the range of 1 to 20 area% means that the total area ratio of the silicon nitride crystalline phases 11 and the melilite crystalline phases 13 is preferably not less than 80% on the cross section of the composite sintered body. Setting the area ratio of the silicon nitride crystalline phases to a range of 9 to 60 area% and the area ratio of the melilite crystalline phases to a range of 25 to 90 area% enables the average thermal expansion coefficient (23°C to 150°C) of the resulting silicon nitride-melilite composite sintered body to be regulated to a range of 2 to 6 ppm/K or preferably to a range of 3 to 5 ppm/K. Such regulation is especially desirable for the favorable matching of the thermal expansion coefficient of the composite sintered body with that of a semiconductor wafer.

Setting the area ratio of the silicon nitride crystalline phases, the area ratio of the melilite crystalline phases, and the area ratio of the glass phases and the other crystalline phases but the silicon nitride crystalline phases and the melilite crystalline phases to the above respective ranges enables the resulting silicon nitride-melilite composite sintered body to have any arbitrary average thermal expansion coefficient in the range of 2 to 6 ppm/K or more preferably in the range of 3 to 5 ppm/K at the temperatures of 23°C to 150°C and the sufficiently high Young's modulus of not lower than 200 GPa.

The ratio (area ratio) of the melilite crystalline phases on the cross section of the silicon nitride-melilite composite sintered body is determinable by any of the techniques, electron probe microanalysis (EPMA), transmission electron microscopy (TEM), scanning electron microscope (SEM), X-ray diffractometry (XRD), and energy dispersive X-ray spectroscopy (EDS). The structure of the crystalline phases included in the composite sintered body, the element ratios of individual particles, and TEM diffraction patterns of the individual particles (when required) are obtained from such measurements. These obtained pieces of information are used to identify the crystalline particles mainly made of Me, Si, O, and N as melilite particles and determine the ratio of the melilite crystalline phases. The identification is made sequentially from crystalline particles of the greater particle diameter in any preset visual field. Similarly, the crystalline particles mainly made of Si and N are identified as silicon nitride particles. The measurement is made in multiple different measurement ranges, each having a squared area of, for example, 50 μm, and the observed values in the respective measurement ranges are averaged. The measurement ranges are not restricted to this example but should be selected adequately without any extreme localization of the microstructures for identification of particles.

The presence of the silicon nitride and the melilite in the silicon nitride-melilite composite sintered body of the embodiment is observable by powder X-ray diffractometry of the composite sintered body. In the X-ray diffraction pattern of the silicon nitride-melilite composite sintered body of the embodiment, it is preferable that a diffraction intensity 'a' of a main peak of the silicon nitride (diffraction intensity of a highest peak among all the peaks of the P silicon nitride) and a diffraction intensity 'b' of a main peak of the melilite (diffraction intensity of a highest peak among all the peaks of the melilite) satisfy a relation of:

$$50 \leq [b/(a+b)] \times 100 \leq 98.$$

The silicon nitride-melilite composite sintered body satisfying the above relation has any arbitrary average thermal expansion coefficient in the range of 2 to 6 ppm/K at the temperatures of 23°C to 150°C.

The silicon nitride-melilite composite sintered body of the embodiment may be manufactured according to a procedure discussed below.

The procedure (i) prepares a powdery mixture by mixing silicon nitride powder, an oxide or a salt of an organic acid containing a metal element Me that combines with silicon nitride to generate a melilite (for example, yttria $Y_2O_3$, yttrium formate, or yttrium carbonate), and an additive (if any) containing at least one element selected among group 2 elements, La, Ce, and Pr with a dispersant and a dispersion medium, such as ethanol, in a ball mill, (ii) dries the prepared powdery mixture, and (iii) granulates the dried powdery mixture to particles. The particles are then pressed or otherwise molded or formed into a body in a desired shape. Remaining dispersant and other organic compounds are removed by heat treatment. The body is sintered in a nitrogen atmosphere of 0.1 to 1.0 MPa in a sintering furnace at temperatures of 1700 to 1800°C for 2 through 8 hours. The sintering method is not specifically restricted, but any suitable technique may be adopted as the sintering method. Any combination of multiple different techniques may also be adopted as the sintering method.

The pressure applied by hot pressing may give the anisotropic property of the microstructure of a resulting composite sintered body. A significant anisotropic property of the microstructure may lead to different average thermal expansion coefficients in different directions of the composite sintered body. A sintering technique other than hot pressing, for example, sintering under ordinary pressure, sintering under gas pressure, or HIP, may thus be preferable to give the isotropic property of the microstructure of the resulting composite sintered body. The hot pressing technique may be adopted for products specifically designed with consideration of the potential anisotropic nature or products with no practical effect of the anisotropic nature.

The silicon nitride-melilite composite sintered body of the embodiment is thus effectively applied as the substrate material or the structural material of a device used for inspection of semiconductor wafers, such as a probe card. The silicon nitride-melilite composite sintered body of the embodiment is also effectively applied as the substrate material or the structural material of a device used for production of semiconductor.

Figs. 2 through 4 are sectional views schematically showing probe cards utilizing the silicon nitride-melilite composite sintered body of the embodiment. A probe card 20 shown in Fig. 2 has a large number of cantilevers 23 mounted on a lower face of a ceramic substrate 21. Probes 25 formed on respective free ends of the multiple cantilevers 23 are brought into contact with terminal pads (not shown) of a semiconductor wafer (not shown). A probe card 30 shown in Fig. 3 has a large number of probes 33 provided on a lower face of a ceramic substrate 31. The probes 33 utilize the buckling stress to come into contact with terminal pads (not shown) of a semiconductor wafer (not shown). The probe 30 of Fig. 3 also has a buckling restriction member 35 to restrict buckling of the probes 33. A probe card 40 shown in Fig. 4 has a cushion member 43 and a membrane 45 mounted on a lower face of a ceramic substrate 41. The ceramic substrate 41 is pressed against a semiconductor wafer (not shown), so that a large number of terminals 47 provided on a lower face of the membrane 45 are brought into contact with terminal pads (not shown) of a semiconductor wafer (not shown).

In these probe cards 20, 30, and 40, the ceramic substrates 21, 31, and 41 are mainly made of the silicon nitride-melilite composite sintered body of the embodiment. The silicon nitride-melilite composite sintered body of the embodiment may also be used for some constituents other than the ceramic substrates 21, 31, and 41. For example, in the probe card 30 of Fig. 3, the buckling restriction member 35 may be made of the silicon nitride-melilite composite sintered body of the embodiment.

Each of the probe cards 20, 30, and 40 utilizes the material having the adequate thermal expansion coefficient. In the case of inspection of the operating conditions of a semiconductor wafer both in a condition from room temperature to high temperatures and in a condition from room temperature to low temperatures, each of the probe cards 20, 30, and 40 assures inspection with the high reliability without causing poor contact of the terminal pads of the semiconductor wafer with the probes or terminals 25, 33, or 47 of the probe card 20, 30, or 40.

The silicon nitride-melilite composite sintered body of the embodiment may be utilized for production of a large-size substrate having a diameter of not smaller than 30 cm or even a diameter of not smaller than 45 cm. The resulting large-size substrate has a low warpage and may even be corrected to be free from warpage by its own weight by sintering. In the case of a thin, large-size alumina substrate having a diameter of 40 cm and a thickness of 7 mm, a warpage of 5 mm occurring in its non-sintered condition is still left as a warpage of 2 to 3 mm even after sintering. Application of loading and heat to this thin, large-size substrate for correction of the warpage may cause cracking. This warpage correcting step undesirably increases the total manufacturing cost. The hot pressing technique may be adopted to sinter such a thin, large-size substrate. It is, however, rather difficult to sinter the thin, large-size substrate in a carbon die under application of loading without causing any damage or breakage. A sintered substrate of the silicon nitride-melilite composite sintered body of the embodiment advantageously has only insignificant warpage of less than 1 mm. Unlike the ordinary ceramic sintering process utilizing the liquid phase sintering mechanism, the sintering process of the silicon nitride-melilite composite sintered body of the embodiment is expected to cause changes and migrations of various elements with a temperature increase to the sintering temperature and eventually complete the melilite crystalline phases through multi-stage changes of the crystalline phases. Namely the sintering process of the silicon nitride-melilite composite sintered body is expected to proceed in a relatively flexible state. The warpage in the non-sintered condition may automatically be corrected by the dead weight of the silicon nitride-melilite composite sintered body in the sintering process.

The silicon nitride-melilite composite sintered body of the embodiment includes the silicon nitride crystalline phases and the melilite crystalline phases having significantly different thermal expansion coefficients. The resulting sintered body, however, does not have micro-cracking caused by a thermal expansion difference. This may be ascribed to the stable existence of the silicon nitride crystalline phases and the melilite crystalline phases and relatively clear separation of the boundaries of these crystalline phases. The clear separation of the boundaries may allow the grain boundary migration to absorb a residual stress caused by the thermal expansion difference.

Another advantage of the silicon nitride-melilite composite sintered body of the embodiment inhibits uneven sintering results between the central area and the peripheral area. Sintering a thin, large-size substrate having a diameter of 40 cm and a thickness of 6 mm causes little characteristic differences, such as unevenness of color and a variation in characteristic between the exterior and the interior of the substrate. The silicon nitride-melilite composite sintered body has a large content of the Me oxide as the melilite component and further contains a certain amount of the other sintering additives. This composition may accelerate densification of the resulting sintered substrate, while preventing vaporization of silicon nitride. Even when a sintering environment in a sintering case is rather unstable, the silicon nitride-melilite composite sintered body of the embodiment gives a stable large-size product.

The silicon nitride-melilite composite sintered body of the embodiment has the thermal expansion characteristic mainly adjusted by the contents of the silicon nitride crystalline phases and the melilite crystalline phases. The silicon nitride-melilite composite sintered body of the embodiment accordingly has the excellent corrosion resistance, compared with a sintered body having the thermal expansion characteristic adjusted by the content of oxide glass phases. The silicon nitride-melilite composite sintered body of the embodiment is thus effectively applicable to parts for a semiconductor production device requiring an etching step. Reduction of the amount of the sintering additive remaining as the glass phases is essential for the further improvement of the corrosion resistance. These manufacturing advantages prove the effective application of the silicon nitride-melilite composite sintered body of the embodiment to substrates.

The silicon nitride-melilite composite sintered body of the embodiment is effectively usable as the material of various substrates. Examples of substrates having members composed of the silicon nitride-melilite composite sintered body of the embodiment are described below with reference to Figs. 5 through 9.

Fig. 5 is a diagrammatic sectional-view representation of one circuit board 100 with a semiconductor element mounted thereon. As illustrated, the circuit board 100 includes a substrate 110 and a semiconductor element 130 arranged on one principal surface 111 of the substrate 110. A frame stiffener 120 is attached to the circuit board 100, such that the semiconductor element 130 is located inside the frame stiffener 120. The stiffener 120 is a reinforcement member and is mainly composed of the silicon nitride-melilite composite sintered body of the embodiment. The semiconductor element 130 may be a Si element (operating temperature range of -50°C to room temperature to 150°C) or a SiC element (operating temperature range of -50°C to room temperature to 350°C).

Even in a high temperature condition of, for example, 350°C, the stiffener 120 mainly composed of the silicon nitride-melilite composite sintered body of the embodiment has a little thermal expansion difference from the semiconductor element 130 and a high potential for flatness. The stiffener 120 may be structured to have the thermal expansion characteristic adjusted considering to the temperature distribution of the circuit board 100. The circuit board 100 of even a small thickness accordingly has a high reliability.

Fig. 6 is a diagrammatic sectional-view representation of another circuit board 200 with a semiconductor element mounted thereon. As illustrated, the circuit board 200 includes a frame substrate 210, and a plate stiffener 220 is attached to one principal surface 211 of the substrate 210. A circuit 222 made of, for example, tungsten is formed inside the plate stiffener 220. A semiconductor element 230, for example, Si or SiC is arranged inside the frame substrate 210 on one face 221 of the plate stiffener 220. The stiffener 220 is mainly composed of the silicon nitride-melilite composite sintered body of the embodiment.

When the circuit 222 is made of the oxidizable material such as tungsten, it is required to sinter the stiffener 220 in a reductive atmosphere. In this case, carbon may not be completely burn out but remain in a via hole of the circuit 222. This 'remaining carbon' may prevent the ceramic material around the via hole of tungsten from being densified or may lower the mechanical strength. Such 'remaining carbon', however, does not have significant effect on the densification and the mechanical strength of the silicon nitride-melilite composite sintered body of the embodiment. The silicon nitride-melilite composite sintered body has a large content of the Me oxide as the melilite component, which accelerates sintering the silicon nitride component and prevents the remaining carbon from decomposing and volatilizing the silicon nitride. The remaining carbon accordingly combines with part of the silicon nitride component to produce SiC, which is stable in the sintered body.

The application of the silicon nitride-melilite composite sintered body of the embodiment to the circuit-including stiffener 220 gives the highly reliable circuit board 200 that is relatively free from the characteristic degradation due to the 'remaining carbon' and has a little thermal expansion difference from the semiconductor element even under a high temperature condition.

Fig. 7 is a diagrammatic perspective-view representation of a heater substrate 300 with a heat pattern. As illustrated, the heater substrate 300 includes a plate substrate 310, a heat pattern 320 formed as a heating element on one principal surface 311 of the plate substrate 310, and electrodes 330 connecting with both ends of the heat pattern 320. The substrate 310 is mainly composed of the silicon nitride-melilite composite sintered body of the embodiment. The heat pattern 320 is made of a heat resistant material, such as tungsten.

When the heat pattern 320 is made of the oxidizable material such as tungsten, it is required to sinter the substrate 310 in a reductive atmosphere. In this case, carbon may not be completely burn out but remain in the heat pattern 320 as the 'remaining carbon'. As mentioned above, such 'remaining carbon' does not have significant effect on the densification and the mechanical strength of the silicon nitride-melilite composite sintered body of the embodiment.

The application of the silicon nitride-melilite composite sintered body of the embodiment having the adequate thermal expansion characteristic and no substantial effect of the 'remaining carbon' to the heater substrate 300 gives a ceramic heater that has a high mechanical strength and a sufficient resistance to thermal shocks induced by repeated temperature variations over a wide temperature range from ordinary temperature to high temperature. The heat pattern 320 is arranged on the surface of the substrate 310 in the illustrated example of Fig. 7 but may alternatively be embedded in the substrate 310.

Circuit boards 400 and 500 shown in Figs. 8 and 9 are other embodiments of the invention. As shown in Fig. 8, the circuit board 400 includes a substrate 410, a semiconductor element 430 arranged on the substrate 410, and a cap structure arranged on the substrate 410. The cap structure has a lid 420 and a frame wall 422 arranged to place the semiconductor element 430 therein. The lid 420 and the wall 422 are mainly composed of the silicon nitride-melilite composite sintered body of the embodiment. As shown in Fig. 9, the circuit board 500 includes a substrate 510, a semiconductor element 530 arranged on the substrate 510, and a cap 520 arranged on the substrate 510 to place the semiconductor element 530 therein. The cap 520 is mainly composed of the silicon nitride-melilite composite sintered body of the embodiment. Although not being specifically illustrated, all the ceramic materials included in the respective circuit boards 100, 200, 400, and 500 may be composed of the silicon nitride-melilite composite sintered body of the embodiment.

Another application of the invention prepares multiple sheets having different ratios of silicon nitrite crystalline phases to melilite crystalline phases (that is, different molar ratios of Si in $Si_3N_4$ equivalent to Me in oxide equivalent) and stacks the multiple sheets. This gives a silicon nitride-melilite composite sintered body laminate usable as a functionally gradient material for production of a substrate. This application may cause the substrate to have bimetal-like characteristics. The presence of layers with different thermal expansion coefficients produces compression stress and gives the high toughness to the substrate.

Examples

To explain the invention some "working examples" and "comparative examples" will now be given though it should be understood that only working examples 45, 46, 48-62 fall within the scope of the claims.

Working Examples 1 to 80 and Comparative Examples 1 and 2

Silicon nitride ($Si_3N_4$) powder having an average particle diameter of 0.7 $\mu$m, yttria ($Y_2O_3$) powder having an average particle diameter of 1.2 $\mu$m, and some of $SrCO_3$ powder, $La_2O_3$ powder, $CeO_2$ powder, and $Al_2O_3$ powder as an additive were used as the materials to prepare diversity of powdery mixtures having the compositions shown in Tables 1 through 6. Each of the resulting powdery mixtures was mixed with ethanol in a ball mill, was heated and dried, and was granulated to particles. Strontium in its oxide form SrO readily combines with the water content to produce a hydroxide, such as $Sr(OH)_2$, in the manufacturing process. Strontium in its carbonate form, such as $SrCO_3$, was thus used as the additive. The strontium content actually added in its carbonate form $SrCO_3$ is expressed as conversion in its oxide SrO equivalent in Tables 1 through 6.

With regard to Working Examples 7 to 20, 24 to 38, and 41 to 80, the particles were pressed into a rectangular parallelepiped body of 70 mm x 70 mm x 20 mm. The prismatic body was subject to cold isostatic pressing (CIP) under a pressure of 98 MPa and was sintered in a nitrogen atmosphere of 0.1 MPa in a sintering furnace at temperatures of 1700 to 1800°C for 4 hours.

With regard to Working Examples 1 to 6 and 21 and Comparative Examples 1 and 2, the particles were pressed into a prismatic body of 70 mm x 70 mm x 20 mm. The prismatic body was placed in a carbon mold and was subject to hot pressing to be densified under a pressure of 30 MPa at a temperature of 1750°C for 2 hours.

With regard to Working Examples 22 and 39, the particles were pressed into a prismatic body of 70 mm × 70 mm × 20 mm. The prismatic body was subject to cold isostatic pressing (CIP) under a pressure of 98 MPa, was sintered in a nitrogen atmosphere of 0.1 MPa in a sintering furnace at a temperature of 1750°C for 4 hours, and was further subject to gas pressure sintering to be densified under a pressure of 8.0 MPa at a temperature of 1700°C for 2 hours.

With regard to Working Examples 23 and 40, the particles were pressed into a prismatic body of 70 mm × 70 mm × 20 mm. The prismatic body was subject to cold isostatic pressing (CIP) under a pressure of 98 MPa, was sintered in a nitrogen atmosphere of 0.1 MPa in a sintering furnace at a temperature of 1750°C for 4 hours, and was further subject to hot isostatic pressing (HIP) under a pressure of 100 MPa at a temperature of 1700°C for 2 hours.

The composite sintered bodies of the respective working examples and comparative examples were evaluated by measurement of various properties and characteristics according to the procedures discussed below.

[Theoretical Density Ratio] The procedure measured the bulk density in conformity with Japanese Industrial Standards JIS R 1634 and calculated a ratio of the measured bulk density to a theoretical density. The theoretical density was computed on the assumption that, for example, the yttria ($Y_2O_3$) powder was fully converted into the melilite ($Me_2Si_3O_3N_4$: Me= Y), that the residual silicon nitride powder remained, and that the other additives were present in the form of oxides. For example, the theoretical density of $Y_2Si_3O_3N_4$ was 4.25 (g/cm$^3$). Under the condition of the theoretical density ratio of not lower than 95%, there was no substantial difference between the apparent density and the bulk density in conformity with JIS R 1634.

[Water Absorption Rate] The procedure defoamed each composite sintered body in water to make the composite sintered body absorb water and dried the water-absorbed composite sintered body. The water absorption rate of the composite sintered body was then calculated according to an equation given below:

$$\text{Water Absorption Rate (\%)} = [(W_1 - W_2)/W_2] \times 100$$

where $W_1$ denotes the weight of the water-absorbed composite sintered body and $W_2$ denotes the weight of the dried composite sintered body. The water absorption rate may be measured in conformity with JIS-R2205.

[Intensity Ratio of Main Peak of Melilite] The procedure crushed and ground each composite sintered body into powder and made the powder subject to powder X-ray diffractometry with, for example, an X-ray diffractometer RU-200T (manufactured by Rigaku Corporation) or an X-ray diffractometer RINT-TTRIII (manufactured by Rigaku Corporation), to measure a diffraction intensity 'b' of a main peak of the melilite ($Me_2Si_3O_3N_4$) and a diffraction intensity 'a' of a main peak of $Si_3N_4$. The intensity ratio of the main peak of the melilite was then calculated according to an equation given below:

$$\text{Melilite Main Peak Intensity Ratio (\%)} = [b/(a+b)] \times 100$$

The X-ray diffractometry reduces the crystalline orientation of each test sample to a sufficiently low level before measurement of diffraction or adopts a measurement method of reducing the crystalline orientation.
The measurement conditions of RING-TTRIII were: monochromator, copper target, tube current of 300 mA, tube voltage of 50 kV, scanning speed of 4°/minute, and sampling width of 0.02°.

The diffraction intensity '*a*' of the main peak of silicon nitride represents a diffraction intensity of a highest peak among all peaks of β silicon nitride. The diffraction intensity '*b*' of the main peak of the melilite represents a diffraction intensity of a highest peak among all peaks of the melilite. Fig. 10 is a graph showing an X-ray diffraction chart of the melilite ($Me_2Si_3O_3N_4$: Me= Y) and the β silicon nitride ($\beta$-$Si_3N_4$). The abscissa of the graph is 2θ that varies in a range of 20° to 40°. As shown in this X-ray diffraction chart, the main peak of the melilite is a peak at a location of 2θ= approximately 32° (A). The main peak of the P silicon nitride is the highest among a peak at a location of 2θ= approximately 27°(B), a peak at a location of 2θ= approximately 34° (C), and a peak at a location of 2θ= approximately 36° (D). The ratio of the X-ray diffraction intensity or the peak intensity is practically equivalent to the ratio of the area intensity or the integral intensity. Because of its simplicity and versatility, the ratio of the diffraction intensity or the peak intensity was used as the ratio of the melilite crystalline phases to the silicon nitride crystalline phases.

[Average Thermal Expansion Coefficient] The procedure measured the average thermal expansion coefficient of each composite sintered body at the temperatures of 23°C to 150°C by thermo-mechanical analysis with a thermo-mechanical analyzer, for example, TMA8310 (manufactured by Rigaku Corporation) in conformity with JIS R 1618. In the specification hereof, the 'average linear expansion coefficient' is synonymous with the 'average thermal expansion coefficient'. Similarly the 'linear expansion coefficient' is synonymous with the 'thermal expansion coefficient'.

[Bending Strength] The procedure measured the three-point bending strength of each composite sintered body at room temperature (23°C) in conformity with JIS R 1601.

[Young's Modulus] The procedure measured the Young's modulus of each composite sintered body at room temperature (23°C) by the ultrasonic pulse method in conformity with JIS R 1602.

[Area Ratio] The procedure processed a surface area of 4 mm × 10 mm in each composite sintered body cut into dimensions of 3 mm × 4 mm × 10 mm by mirror-like finishing and observed the mirror-like finished surface by scanning electron microscopy with an SEM (scanning electron microscope) JSM-6460LA (manufactured by JEOL Ltd). The procedure also observed a secondary electron image and a reflected electron image of the composite sintered body by electron probe microanalysis with an EPMA (electron probe microanalyzer) JXA-8500F (manufactured by JEOL Ltd.) and conducted mapping with a WDS (wavelength dispersive X-ray spectrometer), in order to determine the respective area ratios of the silicon nitride crystalline phases, the melilite crystalline phases, and the grain boundary phases. The grain boundary phases include glass phases and other crystalline phases but the silicon nitride crystalline phases and the melilite crystalline phases and are shown as 'other phase' in Tables 1 through 6. The area ratios were determined on the assumption that a total area other than pores is 100 (area%). When the composite sintered body has a relatively high ratio of the glass phases and the other crystalline phases but the silicon nitride crystalline phases and the melilite crystalline phases, it may be difficult to determine the respective area ratios only by the above instrumental observations. In such cases and otherwise as needed, the procedure further conducted scanning transmission electron microscopy with an STEM (scanning transmission electron microscope) HD-2000 (manufactured by Hitachi High-Technologies Corporation) and energy dispersive X-ray analysis with an EDS (energy dispersive X-ray analyzer) Genesis (manufactured by EDAX Division, AMETEK Inc.). In some cases, the procedure additionally etched the mirror-like finished surface of the composite sintered body and observed the etched surface with the SEM and the other instruments to determine the respective area ratios.

The results of such measurements and evaluations are also shown in Tables 1 through 6. With regard to Working Examples 69 to 80, the amount of surplus oxygen is additionally shown in Table 6.

Table 1

| | | COMPOSITION (mol%) | | | | | | MOLAR RATIO (mol%) | | a1* (℃) | a2* (%) | a3* (%) |
|---|---|---|---|---|---|---|---|---|---|---|---|---|
| | | | | SINTERING ADDITIVES | | | | | | | | |
| | | $Si_3N_4$ | $Y_2O_3$ | SrO | $La_2O_3$ | $CeO_2$ | $Al_2O_3$ | $Si_3N_4$ | $Y_2O_3$ | | | |
| WORKING EXAMPLES | 1 | 83.0 | 17.0 | – | – | – | – | 100.0 | 20.5 | 1750 | 99.2 | 0.03 |
| | 2 | 80.0 | 20.0 | – | – | – | – | 100.0 | 25.0 | 1750 | 99.1 | 0.02 |
| | 3 | 70.0 | 30.0 | – | – | – | – | 100.0 | 42.9 | 1750 | 99.5 | 0.03 |
| | 4 | 65.0 | 35.0 | – | – | – | – | 100.0 | 53.8 | 1750 | 99.3 | 0.03 |
| | 5 | 60.0 | 40.0 | – | – | – | – | 100.0 | 66.7 | 1750 | 99.2 | 0.02 |
| | 6 | 55.0 | 45.0 | – | – | – | – | 100.0 | 81.8 | 1750 | 99.5 | 0.03 |
| | 7 | 50.0 | 45.0 | 5.0 | – | – | – | 100.0 | 90.0 | 1750 | 98.7 | 0.05 |
| | 8 | 49.0 | 46.0 | 5.0 | – | – | – | 100.0 | 93.9 | 1750 | 98.6 | 0.10 |
| | 9 | 58.0 | 37.0 | 5.0 | – | – | – | 100.0 | 63.8 | 1750 | 98.0 | 0.12 |
| | 10 | 79.0 | 13.0 | 8.0 | – | – | – | 100.0 | 16.5 | 1750 | 99.0 | 0.05 |
| | 11 | 75.0 | 15.0 | 10.0 | – | – | – | 100.0 | 20.0 | 1750 | 99.0 | 0.11 |
| | 12 | 70.0 | 20.0 | 10.0 | – | – | – | 100.0 | 28.6 | 1750 | 98.5 | 0.08 |
| | 13 | 65.0 | 25.0 | 10.0 | – | – | – | 100.0 | 38.5 | 1750 | 99.0 | 0.07 |

| | | a4* (%) | a5* (ppm/K) | a6* (MPa) | a7* (GPa) | a8* (area%) | | | a12* (area%) | |
|---|---|---|---|---|---|---|---|---|---|---|
| | | | | | | a9* | a10* | a11* | a13* | a14* |
| WORKING EXAMPLES | 1 | 60 | 2.5 | 650 | 287 | 65 | 34 | 1 | 66 | 34 |
| | 2 | 76 | 2.9 | 630 | 283 | 60 | 39 | 1 | 61 | 39 |
| | 3 | 85 | 3.5 | 570 | 265 | 40 | 59 | 1 | 40 | 60 |
| | 4 | 88 | 4.0 | 530 | 260 | 30 | 69 | 1 | 30 | 70 |
| | 5 | 92 | 4.3 | 510 | 253 | 20 | 79 | 1 | 20 | 80 |
| | 6 | 95 | 4.6 | 460 | 245 | 10 | 89 | 1 | 10 | 90 |
| | 7 | 97 | 5.3 | 480 | 235 | 5 | 92 | 3 | 5 | 95 |
| | 8 | 96 | 5.3 | 480 | 230 | 3 | 94 | 3 | 3 | 97 |
| | 9 | 92 | 4.3 | 600 | 245 | 22 | 75 | 3 | 23 | 77 |
| | 10 | 58 | 2.6 | 700 | 285 | 69 | 27 | 4 | 72 | 28 |
| | 11 | 63 | 2.9 | 700 | 275 | 64 | 31 | 5 | 67 | 33 |
| | 12 | 72 | 3.6 | 650 | 270 | 53 | 42 | 5 | 56 | 44 |
| | 13 | 81 | 4.0 | 600 | 260 | 43 | 52 | 5 | 45 | 55 |

Notes:

The symbols a1* through a14* represent the following properties:

a1*: Firing Temperature a2*: Theoretical Density Ratio
a3*: Water Absorption Rate a4*: Melilite Main Peak Intensity Ratio
a5*: Average Thermal Expansion Coefficient a6*: Bending Strength
a7*: Young's Modulus a8*: Area Ratios
a9*: $Si_3N_4$ Crystalline Phase a10*: Melilite Crystalline Phase
a11*: Other Phase a12*: $Si_3N_4$: Melilite Area Ratio
a13*: $Si_3N_4$ Crystalline Phase a14*: Melilite Crystalline Phase

This representation is similarly applicable to subsequent Tables 2 through 5.

Table 2

| | | COMPOSITION (mol%) | | | | | | MOLAR RATIO (mol%) | | a1* (℃) | a2* (%) | a3* (%) |
|---|---|---|---|---|---|---|---|---|---|---|---|---|
| | | $Si_3N_4$ | $Y_2O_3$ | SINTERING ADDITIVES | | | | $Si_3N_4$ | $Y_2O_3$ | | | |
| | | | | SrO | $La_2O_3$ | $CeO_2$ | $Al_2O_3$ | | | | | |
| WORKING EXAMPLES | 14 | 60.0 | 30.0 | 10.0 | – | – | – | 100.0 | 50.0 | 1750 | 98.5 | 0.05 |
| | 15 | 55.0 | 35.0 | 10.0 | – | – | – | 100.0 | 63.6 | 1750 | 99.0 | 0.05 |
| | 16 | 50.0 | 40.0 | 10.0 | – | – | – | 100.0 | 80.0 | 1750 | 99.0 | 0.04 |
| | 17 | 52.0 | 33.0 | 15.0 | – | – | – | 100.0 | 63.5 | 1750 | 99.0 | 0.06 |
| | 18 | 41.0 | 39.0 | 20.0 | – | – | – | 100.0 | 95.1 | 1750 | 99.5 | 0.03 |
| | 19 | 62.0 | 18.0 | 20.0 | – | – | – | 100.0 | 29.0 | 1750 | 99.5 | 0.03 |
| | 20 | 52.0 | 46.0 | 2.0 | – | – | – | 100.0 | 88.5 | 1750 | 92.0 | 1.80 |
| | 21 | 52.0 | 46.0 | 2.0 | – | – | – | 100.0 | 88.5 | 1750 | 99.2 | 0.01 |
| | 22 | 50.0 | 47.0 | 3.0 | – | – | – | 100.0 | 94.0 | 1750 | 99.0 | 0.05 |
| | 23 | 52.0 | 46.0 | 2.0 | – | – | – | 100.0 | 88.5 | 1750 | 99.5 | 0.05 |
| | 24 | 46.0 | 29.0 | 25.0 | – | – | – | 100.0 | 63.0 | 1750 | 99.1 | 0.03 |
| | 25 | 43.0 | 27.0 | 30.0 | – | – | – | 100.0 | 62.8 | 1750 | 98.5 | 0.03 |

| | | a4* (%) | a5* (ppm/K) | a6* (MPa) | a7* (GPa) | a8* (area%) | | | a12* (area%) | |
|---|---|---|---|---|---|---|---|---|---|---|
| | | | | | | a9* | a10* | a11* | a13* | a14* |
| WORKING EXAMPLES | 14 | 86 | 4.3 | 610 | 250 | 32 | 63 | 5 | 34 | 66 |
| | 15 | 92 | 4.5 | 550 | 240 | 21 | 73 | 6 | 22 | 78 |
| | 16 | 95 | 5.0 | 500 | 235 | 11 | 84 | 5 | 12 | 88 |
| | 17 | 92 | 4.7 | 500 | 235 | 21 | 71 | 8 | 23 | 77 |
| | 18 | 98 | 6.0 | 450 | 210 | 2 | 87 | 11 | 2 | 98 |
| | 19 | 75 | 4.5 | 550 | 250 | 49 | 40 | 11 | 55 | 45 |
| | 20 | 97 | 5.3 | 150 | 181 | 5 | 92 | 3 | 5 | 95 |
| | 21 | 97 | 5.3 | 510 | 240 | 5 | 92 | 3 | 5 | 95 |
| | 22 | 97 | 5.4 | 450 | 235 | 3 | 95 | 2 | 3 | 97 |
| | 23 | 96 | 5.1 | 470 | 238 | 6 | 92 | 2 | 6 | 94 |
| | 24 | 92 | 5.3 | 300 | 200 | 20 | 66 | 14 | 23 | 77 |
| | 25 | 92 | 5.7 | 250 | 180 | 18 | 61 | 21 | 23 | 77 |

Table 3

| | COMPOSITION (mol%) | | | | | | MOLAR RATIO (mol%) | | a1* (℃) | a2* (%) | a3* (%) |
|---|---|---|---|---|---|---|---|---|---|---|---|
| | | | SINTERING ADDITIVES | | | | | | | | |
| | $Si_3N_4$ | $Y_2O_3$ | SrO | $La_2O_3$ | $CeO_2$ | $Al_2O_3$ | $Si_3N_4$ | $Y_2O_3$ | | | |
| WORKING EXAMPLES 26 | 51.0 | 48.7 | – | 0.3 | – | – | 100.0 | 95.5 | 1750 | 98.0 | 0.18 |
| 27 | 50.5 | 49.0 | – | 0.5 | – | – | 100.0 | 97.0 | 1750 | 99.2 | 0.03 |
| 28 | 55.0 | 44.0 | – | 1.0 | – | – | 100.0 | 80.0 | 1750 | 99.0 | 0.06 |
| 29 | 83.0 | 15.0 | – | 2.0 | – | – | 100.0 | 18.1 | 1750 | 98.8 | 0.11 |
| 30 | 76.0 | 22.0 | – | 2.0 | – | – | 100.0 | 28.9 | 1750 | 98.5 | 0.08 |
| 31 | 71.0 | 27.0 | – | 2.0 | – | – | 100.0 | 38.0 | 1750 | 99.0 | 0.05 |
| 32 | 65.0 | 33.0 | – | 2.0 | – | – | 100.0 | 50.8 | 1750 | 98.5 | 0.15 |
| 33 | 60.0 | 38.0 | – | 2.0 | – | – | 100.0 | 63.3 | 1750 | 99.0 | 0.08 |
| 34 | 60.0 | 37.6 | – | 2.4 | – | – | 100.0 | 62.7 | 1750 | 98.1 | 0.18 |
| 35 | 81.0 | 16.0 | – | 3.0 | – | – | 100.0 | 19.8 | 1750 | 99.0 | 0.05 |
| 36 | 45.0 | 45.0 | – | 10.0 | – | – | 100.0 | 100.0 | 1750 | 99.0 | 0.06 |
| 37 | 54.0 | 34.0 | – | 12.0 | – | – | 100.0 | 63.0 | 1750 | 98.6 | 0.11 |
| 38 | 55.0 | 44.9 | – | 0.1 | – | – | 100.0 | 81.6 | 1750 | 92.0 | 2.30 |
| 39 | 55.0 | 44.9 | – | 0.1 | – | – | 100.0 | 81.6 | 1750 | 99.5 | 0.03 |
| 40 | 60.0 | 39.9 | – | 0.1 | – | – | 100.0 | 66.5 | 1750 | 99.1 | 0.06 |
| 41 | 45.0 | 40.0 | – | 15.0 | – | – | 100.0 | 88.9 | 1750 | 98.5 | 0.05 |
| 42 | 43.0 | 39.0 | – | – | 18.0 | – | 100.0 | 90.7 | 1750 | 98.2 | 0.11 |
| 43 | 43.0 | 37.0 | – | – | 20.0 | – | 100.0 | 86.0 | 1750 | 98.0 | 0.11 |
| 44 | 51.0 | 22.0 | 15.5 | – | 11.0 | 0.5 | 100.0 | 43.1 | 1700 | 98.5 | 0.05 |

| | a4* (%) | a5* (ppm/K) | a6* (MPa) | a7* (GPa) | a8* (area%) | | | a12* (area%) | |
|---|---|---|---|---|---|---|---|---|---|
| | | | | | a9* | a10* | a11* | a13* | a14* |
| WORKING EXAMPLES 26 | 98 | 5.3 | 450 | 235 | 2 | 97 | 1 | 2 | 98 |
| 27 | 98 | 5.3 | 450 | 235 | 2 | 97 | 1 | 2 | 98 |
| 28 | 95 | 4.7 | 500 | 240 | 11 | 87 | 2 | 11 | 89 |
| 29 | 62 | 2.6 | 700 | 290 | 68 | 30 | 2 | 69 | 31 |
| 30 | 71 | 3.3 | 650 | 275 | 54 | 43 | 3 | 56 | 44 |
| 31 | 82 | 3.7 | 600 | 265 | 44 | 53 | 3 | 45 | 55 |
| 32 | 85 | 4.0 | 600 | 255 | 32 | 65 | 3 | 33 | 67 |
| 33 | 93 | 4.2 | 580 | 250 | 22 | 75 | 3 | 23 | 77 |
| 34 | 90 | 4.5 | 550 | 250 | 22 | 74 | 4 | 23 | 77 |
| 35 | 62 | 2.7 | 700 | 280 | 65 | 31 | 4 | 68 | 32 |
| 36 | 98 | 5.8 | 450 | 215 | 2 | 86 | 12 | 2 | 98 |
| 37 | 92 | 4.9 | 550 | 230 | 20 | 66 | 14 | 23 | 77 |
| 38 | 95 | 4.7 | 120 | 183 | 10 | 88 | 2 | 10 | 90 |
| 39 | 94 | 4.7 | 480 | 240 | 10 | 89 | 1 | 10 | 90 |
| 40 | 90 | 4.3 | 500 | 250 | 20 | 79 | 1 | 20 | 80 |
| 41 | 96 | 6.2 | 200 | 206 | 5 | 78 | 17 | 6 | 94 |
| 42 | 97 | 7.0 | 230 | 201 | 4 | 77 | 19 | 5 | 95 |
| 43 | 94 | 7.1 | 200 | 190 | 6 | 72 | 22 | 8 | 92 |
| 44 | 85 | 4.5 | 550 | 225 | 34 | 51 | 15 | 40 | 60 |

Table 4

| | | COMPOSITION (mol%) | | | | | | MOLAR RATIO (mol%) | | a1* (℃) | a2* (%) | a3* (%) |
|---|---|---|---|---|---|---|---|---|---|---|---|---|
| | | $Si_3N_4$ | $Y_2O_3$ | SINTERING ADDITIVES | | | | $Si_3N_4$ | $Y_2O_3$ | | | |
| | | | | SrO | $La_2O_3$ | $CeO_2$ | $Al_2O_3$ | | | | | |
| WORKING EXAMPLES | 45 | 50.0 | 22.0 | 11.0 | - | 11.0 | 6.0 | 100.0 | 44.0 | 1700 | 98.7 | 0.05 |
| | 46 | 50.0 | 20.0 | 10.0 | - | 10.0 | 10.0 | 100.0 | 40.0 | 1700 | 99.1 | 0.03 |
| | 47 | 54.0 | 34.0 | 9.0 | 3.0 | - | - | 100.0 | 63.0 | 1725 | 99.0 | 0.02 |
| | 48 | 57.0 | 37.0 | - | 2.0 | - | 4.0 | 100.0 | 64.9 | 1725 | 98.4 | 0.06 |
| | 49 | 57.0 | 37.0 | - | - | 3.0 | 3.0 | 100.0 | 64.9 | 1725 | 98.2 | 0.14 |
| | 50 | 57.0 | 30.0 | 10.0 | - | - | 3.0 | 100.0 | 52.6 | 1725 | 98.9 | 0.25 |
| | 51 | 54.0 | 29.0 | 14.0 | - | - | 3.0 | 100.0 | 53.7 | 1725 | 99.2 | 0.05 |
| | 52 | 53.0 | 35.0 | 9.0 | - | - | 3.0 | 100.0 | 66.0 | 1725 | 99.9 | 0.03 |
| | 53 | 73.0 | 15.0 | 9.0 | - | - | 3.0 | 100.0 | 20.5 | 1725 | 98.5 | 0.08 |
| | 54 | 60.0 | 28.0 | 9.0 | - | - | 3.0 | 100.0 | 46.7 | 1725 | 98.7 | 0.06 |
| | 55 | 45.0 | 43.0 | 9.0 | - | - | 3.0 | 100.0 | 95.6 | 1725 | 99.1 | 0.04 |
| | 56 | 43.0 | 40.0 | 9.0 | - | - | 8.0 | 100.0 | 93.0 | 1725 | 99.2 | 0.05 |
| | 57 | 70.1 | 17.1 | 9.4 | - | - | 3.4 | 100.0 | 24.4 | 1700 | 98.7 | 0.06 |
| | 58 | 62.7 | 24.5 | 9.4 | - | - | 3.4 | 100.0 | 39.1 | 1700 | 98.9 | 0.07 |
| | 59 | 57.3 | 29.9 | 9.4 | - | - | 3.4 | 100.0 | 52.2 | 1700 | 99.2 | 0.05 |
| | 60 | 52.0 | 35.2 | 9.4 | - | - | 3.4 | 100.0 | 67.7 | 1700 | 99.1 | 0.04 |
| | 61 | 51.0 | 22.0 | 13.0 | - | 11.0 | 3.0 | 100.0 | 43.1 | 1700 | 98.4 | 0.03 |
| | 62 | 54.0 | 23.0 | 14.0 | - | 6.0 | 3.0 | 100.0 | 42.6 | 1700 | 98.9 | 0.03 |
| | 63 | 41.0 | 35.0 | 9.0 | - | - | 15.0 | 100.0 | 85.4 | 1725 | 98.5 | 0.10 |

| | | a4* (%) | a5* (ppm/K) | a6* (MPa) | a7* (GPa) | a8* (area%) | | | a12* (area%) | |
|---|---|---|---|---|---|---|---|---|---|---|
| | | | | | | a9* | a10* | a11* | a13* | a14* |
| WORKING EXAMPLES | 45 | 85 | 4.8 | 500 | 230 | 33 | 50 | 17 | 40 | 60 |
| | 46 | 82 | 4.7 | 500 | 240 | 35 | 46 | 19 | 43 | 57 |
| | 47 | 91 | 4.8 | 550 | 240 | 21 | 71 | 8 | 23 | 77 |
| | 48 | 92 | 4.5 | 530 | 250 | 20 | 75 | 5 | 21 | 79 |
| | 49 | 93 | 4.6 | 550 | 250 | 21 | 76 | 3 | 22 | 78 |
| | 50 | 87 | 4.5 | 530 | 245 | 29 | 64 | 7 | 31 | 69 |
| | 51 | 87 | 4.6 | 500 | 240 | 27 | 63 | 10 | 30 | 70 |
| | 52 | 91 | 4.7 | 520 | 240 | 19 | 74 | 7 | 20 | 80 |
| | 53 | 67 | 3.1 | 650 | 277 | 62 | 31 | 7 | 67 | 33 |
| | 54 | 86 | 4.1 | 570 | 250 | 34 | 59 | 7 | 37 | 63 |
| | 55 | 97 | 5.6 | 450 | 230 | 2 | 91 | 7 | 2 | 98 |
| | 56 | 96 | 5.5 | 470 | 225 | 3 | 87 | 10 | 3 | 97 |
| | 57 | 72 | 3.3 | 940 | 255 | 54 | 36 | 10 | 60 | 40 |
| | 58 | 85 | 3.9 | 740 | 240 | 39 | 51 | 10 | 43 | 57 |
| | 59 | 90 | 4.4 | 550 | 225 | 27 | 63 | 10 | 30 | 70 |
| | 60 | 95 | 4.9 | 470 | 220 | 16 | 74 | 10 | 18 | 82 |
| | 61 | 91 | 4.5 | 500 | 225 | 34 | 50 | 16 | 40 | 60 |
| | 62 | 90 | 4.5 | 500 | 240 | 35 | 51 | 14 | 41 | 59 |
| | 63 | 94 | 5.8 | 350 | 185 | 2 | 76 | 22 | 3 | 97 |

Table 5

| | | COMPOSITION (mol%) | | | | | | MOLAR RATIO (mol%) | | a1* (℃) | a2* (%) | a3* (%) |
|---|---|---|---|---|---|---|---|---|---|---|---|---|
| | | $Si_3N_4$ | $Y_2O_3$ | SINTERING ADDITIVES | | | | $Si_3N_4$ | $Y_2O_3$ | | | |
| | | | | SrO | $La_2O_3$ | $CeO_2$ | $Al_2O_3$ | | | | | |
| WORKING EXAMPLES | 64 | 80.0 | 20.0 | – | – | – | – | 100.0 | 25.0 | 1750 | 83.0 | 6.50 |
| | 65 | 70.0 | 30.0 | – | – | – | – | 100.0 | 42.9 | 1750 | 85.0 | 4.00 |
| | 66 | 65.0 | 35.0 | – | – | – | – | 100.0 | 53.8 | 1750 | 87.0 | 3.50 |
| | 67 | 60.0 | 40.0 | – | – | – | – | 100.0 | 66.7 | 1750 | 90.0 | 2.60 |
| | 68 | 55.0 | 45.0 | – | – | – | – | 100.0 | 81.8 | 1750 | 91.9 | 2.31 |
| COMPARATIVE EXAMPLES | 1 | 90.0 | 10.0 | – | – | – | – | 100.0 | 11.1 | 1750 | 99.1 | 0.05 |
| | 2 | 40.0 | 60.0 | – | – | – | – | 100.0 | 150.0 | 1750 | 99.0 | 0.03 |

| | | a4* (%) | a5* (ppm/K) | a6* (MPa) | a7* (GPa) | a8* (area%) | | | a12* (area%) | |
|---|---|---|---|---|---|---|---|---|---|---|
| | | | | | | a9* | a10* | a11* | a13* | a14* |
| WORKING EXAMPLES | 64 | 73 | 2.8 | 110 | 216 | 59 | 40 | 1 | 60 | 40 |
| | 65 | 85 | 3.6 | 120 | 201 | 39 | 60 | 1 | 39 | 61 |
| | 66 | 88 | 3.9 | 130 | 197 | 31 | 68 | 1 | 31 | 69 |
| | 67 | 92 | 4.3 | 150 | 190 | 21 | 78 | 1 | 21 | 79 |
| | 68 | 96 | 4.6 | 110 | 180 | 9 | 90 | 1 | 9 | 91 |
| COMPARATIVE EXAMPLES | 1 | 57 | 1.7 | 660 | 300 | 80 | 19 | 1 | 81 | 19 |
| | 2 | 100 | 6.2 | 350 | 190 | 0 | 78 | 22 | 0 | 100 |

Table 6

| | | COMPOSITION (mol%) | | | | | | | a16* (mol%) | | | | |
|---|---|---|---|---|---|---|---|---|---|---|---|---|---|
| | | $Si_3N_4$ | $Y_2O_3$ | SINTERING ADDITIVES | | | | a15* (mol%) | $Si_3N_4$ | $Y_2O_3$ | a1* (℃) | a2* (%) | a3* (%) |
| | | | | SrO | $La_2O_3$ | $CeO_2$ | $Al_2O_3$ | $SiO_2$ | | | | | |
| WORKING EXAMPLES | 69 | 54.5 | 29.7 | 9.4 | – | – | 3.4 | 3.0 | 100.0 | 54.5 | 1750 | 98.5 | 0.10 |
| | 70 | 54.0 | 29.5 | 9.0 | – | – | 3.5 | 4.0 | 100.0 | 54.6 | 1750 | 99.5 | 0.03 |
| | 71 | 52.5 | 28.5 | 9.0 | – | – | 3.5 | 6.5 | 100.0 | 54.3 | 1700 | 99.6 | 0.02 |
| | 72 | 51.0 | 28.0 | 9.0 | – | – | 3.0 | 9.0 | 100.0 | 54.9 | 1700 | 99.5 | 0.03 |
| | 73 | 49.0 | 27.0 | 8.5 | – | – | 3.0 | 12.5 | 100.0 | 55.1 | 1700 | 99.5 | 0.03 |
| | 74 | 47.0 | 26.0 | 8.0 | – | – | 3.0 | 16.0 | 100.0 | 55.3 | 1700 | 99.3 | 0.05 |
| | 75 | 45.5 | 24.5 | 8.0 | – | – | 3.0 | 19.0 | 100.0 | 53.8 | 1700 | 99.0 | 0.08 |
| | 76 | 44.0 | 24.0 | 7.5 | – | – | 2.5 | 22.0 | 100.0 | 54.5 | 1700 | 99.0 | 0.11 |
| | 77 | 64.3 | 16.4 | 9.0 | – | – | 3.2 | 7.1 | 100.0 | 25.5 | 1700 | 98.7 | 0.06 |
| | 78 | 57.4 | 23.4 | 9.0 | – | – | 3.3 | 6.9 | 100.0 | 40.8 | 1700 | 98.9 | 0.07 |
| | 79 | 52.4 | 28.6 | 9.0 | – | – | 3.3 | 6.7 | 100.0 | 54.6 | 1700 | 99.2 | 0.05 |
| | 80 | 47.5 | 33.7 | 9.0 | – | – | 3.3 | 6.5 | 100.0 | 70.9 | 1700 | 99.1 | 0.04 |

| | | a4* (%) | a5* (ppm/K) | a6* (MPa) | a7* (GPa) | a8* (area%) | | | a12* (area%) | |
|---|---|---|---|---|---|---|---|---|---|---|
| | | | | | | a9* | a10* | a11* | a13* | a14* |
| WORKING EXAMPLES | 69 | 88 | 4.4 | 700 | 237 | 27 | 64 | 9 | 30 | 70 |
| | 70 | 88 | 4.5 | 700 | 237 | 27 | 63 | 10 | 30 | 70 |
| | 71 | 89 | 4.5 | 680 | 234 | 27 | 62 | 11 | 30 | 70 |
| | 72 | 88 | 4.6 | 620 | 232 | 26 | 62 | 12 | 30 | 70 |
| | 73 | 89 | 4.6 | 550 | 229 | 25 | 61 | 14 | 29 | 71 |
| | 74 | 88 | 4.6 | 500 | 226 | 24 | 59 | 17 | 29 | 71 |
| | 75 | 89 | 4.7 | 400 | 220 | 25 | 57 | 18 | 30 | 70 |
| | 76 | 89 | 4.7 | 260 | 215 | 24 | 57 | 19 | 30 | 70 |
| | 77 | 72 | 3.3 | 940 | 255 | 54 | 36 | 10 | 60 | 40 |
| | 78 | 85 | 3.9 | 740 | 240 | 39 | 51 | 10 | 43 | 57 |
| | 79 | 90 | 4.4 | 550 | 225 | 27 | 63 | 10 | 30 | 70 |
| | 80 | 95 | 4.9 | 470 | 220 | 16 | 74 | 10 | 18 | 82 |

Notes:
The symbols a1* through a16* represent the following properties:
a1*: Firing Temperature
a2*: Theoretical Density Ratio
a3*: Water Absorption Rate
a4*: Melilite Main Peak Intensity Ratio
a5*: Average Thermal Expansion Coefficient
a6*: Bending Strength
a7*: Young's Modulus
a8*: Area Ratios
a9*: $Si_3N_4$ Crystalline Phase
a10*: Melilite Crystalline Phase
a11*: Other Phase
a12*: $Si_3N_4$: Melilite Area Ratio
a13*: $Si_3N_4$ Crystalline Phase
a14*: Melilite Crystalline Phase
a15*: Surplus Oxygen
a16*: Molar Ratio

As clearly shown in Tables 1 through 6, the silicon nitride-melilite composite sintered bodies of Working Examples 1 to 80 had (i) the silicon nitride crystalline phases, (ii) the melilite crystalline phases of $Me_2Si_3O_3N_4$ where Me denotes a metal element combining with silicon nitride to generate the melilite, and (iii) the grain boundary phases. The ratio of the melilite crystalline phases was not less than 20 area% on the cross section of the composite sintered body. The resulting composite sintered bodies of these Working Examples had the arbitrarily adjustable average thermal expansion coefficient at the temperatures of 23°C to 150°C and mostly had the sufficiently high levels of the bending strength and the Young's modulus. The composite sintered bodies of Working Examples 20, 38, and 64 through 68, however, had relatively low theoretical density ratios and thereby the relatively low levels of the bending strength and the Young's modulus, while having sufficient levels of the average thermal expansion coefficient (23°C to 150°C). These composite sintered bodies are still usable for various applications, for example, a porous material and a metallic impregnation material. The composite sintered body of Comparative Example 1, on the other hand, had a low ratio of the melilite crystalline phases and thereby an undesirably low average thermal expansion coefficient (23°C to 150°C). The composite sintered body of Comparative Example 2 had no silicon nitride crystalline phases. Irrespective of densification with the relatively high theoretical density ratio, the composite sintered body of Comparative Example 2 had an undesirably low level of the Young's modulus and a high average thermal expansion coefficient (23°C to 150°C).

In the silicon nitride-melilite composite sintered bodies of Working Examples 1 to 19, 21 to 24, 26 to 37, 39 to 42, 44 to 62, and 69 to 80, the water absorption rate was not higher than 1.5 %, and the sum of the ratio of the melilite crystalline phases and the ratio of the silicon nitride crystalline phases was not less than 80 area% on the cross section of the composite sintered body. The resulting composite sintered bodies of these Working Examples all had the sufficiently high Young's modulus of not lower than 200 GPa and the sufficiently high bending strength of not lower than 200 MPa. The composite sintered bodies of Working Example 64 to 68 with the water absorption rate of higher than 1.5% had the relatively low levels of the bending strength, while having sufficient levels of the average thermal expansion coefficient (23°C to 150°C). These composite sintered bodies are still usable for various applications, for example, a porous material and a metallic impregnation material.

The silicon nitride-melilite composite sintered bodies of Working Examples 1 to 6 had Si in a range of 41 to 83 mol% in $Si_3N_4$ equivalent and Y in a range of 13 to 50 mol% in oxide equivalent but included no additives. The composite sintered bodies of these Working Examples were prepared by hot pressing and had the adequate average thermal expansion coefficient in the range of 2 to 6 ppm/K at the temperatures of 23°C to 150°C, the favorable bending strength, and the favorable Young's modulus. The composite sintered body of Comparative Example 1 had the content of silicon nitride of not lower than 90 mol% and accordingly had an undesirably low ratio of the melilite crystalline phases and an undesirably low average thermal expansion coefficient (23°C to 150°C). The composite sintered body of Comparative Example 2, on the other hand, had the content of silicon nitride of not higher than 40 mol% and thereby had no silicon nitride crystalline phases remain after sintering and an undesirably high average thermal expansion coefficient (23°C to 150°C).

The silicon nitride-melilite composite sintered bodies of Working Examples 7 to 19 had Si in a range of 41 to 79 mol% in $Si_3N_4$ equivalent, Y in a range of 13 to 46 mol% in oxide equivalent, and a group 2 element Sr in a range of 5 to 20 mol% in oxide equivalent. The composite sintered bodies of these Working Examples had the more excellent sinterability, compared with the composite sintered bodies of Working Examples 20 to 23 having the less content of Sr than 5 mol% in oxide equivalent. The composite sintered bodies of Working Examples 7 to 19 all had the adequate average thermal expansion coefficient in the range of 2 to 6 ppm/K at the temperatures of 23°C to 150°C, the high bending strength, and the high Young's modulus. The composite sintered bodies of Working Example 24 and 25 having the greater content of Sr than 20 mol% in oxide equivalent had the decreasing tendencies of the Young's modulus and the mechanical strength.

The silicon nitride-melilite composite sintered bodies of Working Examples 26 to 37 had Si in a range of 45 to 83 mol% in $Si_3N_4$ equivalent, Y in a range of 15 to 49 mol% in oxide equivalent, and La in a range of 0.3 to 12 mol% in oxide equivalent. The composite sintered bodies of these Working Examples had the more excellent sinterability, compared with the composite sintered bodies of Working Examples 38 to 40 having the less content of La than 0.3 mol% in oxide equivalent. The composite sintered bodies of Working Examples 26 to 37 all had the adequate average thermal expansion coefficient in the range of 2 to 6 ppm/K at the temperatures of 23°C to 150°C, the high bending strength, and the high Young's modulus. The composite sintered body of Working Example 41 having the greater content of La than 12 mol% in oxide equivalent and the composite sintered bodies of Working Examples 42 and 43 having the greater content of Ce than 12 mol% in oxide equivalent had the increasing tendency of the average thermal expansion coefficient (23°C to 150°C) and the decreasing tendency of the mechanical strength.

The silicon nitride-melilite composite sintered bodies of Working Examples 44 to 63 and 69 to 80 had Si in a range of 41 to 83 mol% in $Si_3N_4$ equivalent, Y in a range of 13 to 49 mol% in oxide equivalent, Sr in a range of 0 to 20 mol% in oxide equivalent, and La or Ce in a range of 0 to 12 mol% in oxide equivalent. The composite sintered bodies of these Working Examples also had the good sinterability, the adequate average thermal expansion coefficient in the range of 2 to 6 ppm/K at the temperatures of 23°C to 150°C, the high bending strength, and the high Young's modulus. Among these Working Examples, especially the composite sintered bodies of Working Examples 44 to 46, 48 to 62, and 69 to 80 further containing Al as an additive in a range of 0.5 to 10 mol% in oxide equivalent had the more stable sinterability. The composite sintered body of Working Example 63 containing 15 mol% of A1 in oxide equivalent, however, had the increasing tendency of the ratio of glass phases other than the silicon nitride crystalline phases and the melilite crystalline phases and the decreasing tendency of the Young's modulus.

Working Examples 57, 58, 77, and 78 performed longer-time blending (for example, crushing and mixing for 60 hours) of the powdery mixture and ethanol in the ball mill. The resulting composite sintered bodies of these Working Examples had the finer microstructures and the higher strengths.

As clearly shown in Table 6, the amount of surplus oxygen in a specific range assured the favorable sinterability, but an excessive amount of surplus oxygen undesirably lowered the bending strength.

Among various Examples shown in Tables 1 through 6, in some Working Examples containing La or Ce as the additive, La or Ce may be replaced with Pr as the additive. In some Working Examples containing Sr as the additive, Sr may be replaced with Mg or Ca as the additive. Such modifications assure the similar effects to those of the corresponding Working Examples discussed above. In some Working Examples containing Al as the additive, Al may be replaced with at least one element selected among Al, Si, group 4 elements, group 5 elements, and group 6 elements as the additive. Such modification assures the similar effect of stabling the sinterability to those of the corresponding Working Examples discussed above.

The silicon nitride-melilite composite sintered body of the invention may be utilized to provide a probe card used for inspection of semiconductor wafers, a device for inspection of semiconductor, and a device for production of semiconductor, which have the high mechanical strength and the average thermal expansion coefficient arbitrarily adjustable in a range of 2 to 6 ppm/K in a temperature range of room temperature (23°C) to 150°C. The silicon nitride-melilite composite sintered body of the invention may also be utilized to provide a substrate and a stiffener, which have the average thermal expansion coefficient arbitrarily adjustable in the above range and a low warpage (or a high potential for flatness). The silicon nitride-melilite composite sintered body of the invention is effectively applicable to a substrate requiring the high mechanical strength and the high corrosion resistance.

The silicon nitride crystalline phases and the melilite crystalline phases have no significant change in the crystal structure over a wide temperature range from low temperature to high temperature. As the temperature gradually increases from room temperature, oxidation of the melilite crystals starts at approximately 700°C, so that the silicon nitride-melilite composite sintered body of the invention is not preferable in applications at high temperatures of or over 700°C in an oxidizing atmosphere. The silicon nitride-melilite composite sintered body of the invention has the average thermal expansion coefficient mainly adjusted not by the content of the glass phases but by the contents of the silicon nitride crystalline phases and the melilite crystalline phases. The results of repeated tests show stable thermal expansion behaviors over a wide temperature range from a relatively low temperature condition (for example, -50°C) to a relatively high temperature condition (for example, 350°C as the operating temperature of SiC semiconductor). This assures stable inspection. For example, the results of semiconductor wafer tests show substantially matching thermal expansion behaviors over a wide temperature range from low temperature to high temperature. This advantageously expands the coverage of inspection.

In the silicon nitride-melilite composite sintered body of the embodiment, the content of the melilite crystalline phases has no substantial variation against the sintering temperature in a temperature range of 1700°C to 1800°C. Namely the melilite crystalline phases are stably generated in this sintering temperature range of 1700°C to 1800°C. Fig. 11 is a graph of melilite main peak intensity ratios of melilite crystalline phases plotted against the sintering temperature with regard to composite sintered bodies of Working Examples 65 to 67 sintered at temperatures of 1700°C to 1800°C. Fig. 12 is a graph of melilite main peak intensity ratios of melilite crystalline phases plotted against the sintering temperature with regard to composite sintered bodies of Working Examples 58 to 60 sintered at the temperatures of 1700°C to 1800°C. These results prove stable generation of the melilite crystalline phases over this sintering temperature range. This characteristic assures stable mass production. Another advantage is stable generation of the melilite crystalline phases in various dimensions of composite sintered bodies. This characteristic assures application to substrates of various sizes and shapes.

Other embodiments and applications of the invention are described below. The silicon nitride-melilite composite sintered body according to the first aspect of the invention may be actualized by any of various arrangements and applications discussed below.

In one preferable application, the silicon nitride-melilite composite sintered body according to the first aspect of the invention has a water absorption rate of not higher than 1.5%, and a sum of the ratio of the melilite crystalline phases and the ratio of the silicon nitride crystalline phases is not less than 80% on the cross section of the composite sintered body.

The silicon nitride-melilite composite sintered body of this application is a dense composite sintered body having the water absorption rate of not higher than 1.5%. The ratio of the melilite crystalline phases is not less than 20 area% on the cross section of the silicon nitride-melilite composite sintered body. The sum of the ratio of the melilite crystalline phases and the ratio of the silicon nitride crystalline phases is not less than 80 area% on the cross section of the composite sintered body. The silicon nitride-melilite composite sintered body of the embodiment accordingly has a sufficiently large ratio of the crystallized parts. The high density of the composite sintered body has a less decrease of the Young's modulus due to the presence of pores, while the crystallized parts contribute to increase the Young's modulus. The silicon nitride-melilite composite sintered body of the embodiment accordingly has the high Young's modulus.

In the silicon nitride-melilite composite sintered body according to the first aspect of the invention, the ratio of the silicon nitride crystalline phases and the ratio of the melilite crystalline phases may be determined by any of the techniques, electron probe microanalysis (EPMA), transmission electron microscopy (TEM), scanning electron microscopy (SEM), X-ray diffractometry (XRD), and energy dispersive X-ray spectroscopy (EDS). Etching the surface of the composite sintered body other than the crystallized parts (for example, plasma etching with $CF_4$ or chemical etching with hydrofluoric acid) allows for the more precise analyses.

In still another preferable embodiment, the silicon nitride-melilite composite sintered body according to the first aspect of the invention contains Si in a range of 41 to 79 mol% in $Si_3N_4$ equivalent, Me in a range of 13 to 46 mol% in oxide equivalent, and a group 2 element as an additive in a range of 5 to 20 mol% in oxide equivalent.

The silicon nitride-melilite composite sintered body of the embodiment has the desirable composition for the enhanced sinterability. The adequate content of the group 2 element as the additive allows for production of the composite sintered body by sintering at ordinary pressure, as well as by sintering under a pressurizing condition, for example, gas pressure sintering, hot isostatic pressing, or hot pressing. This arrangement accordingly has the industrial advantages, for example, the reduced restrictions on the dimensions and the shape of the resulting composite sintered body and the lowered manufacturing cost by large scale production.

In the silicon nitride-melilite composite sintered body of the above embodiment containing Si in the range of 41 to 79 mol% in $Si_3N_4$ equivalent, Me in the range of 13 to 46 mol% in oxide equivalent, and the group 2 element as the additive in the range of 5 to 20 mol% in oxide equivalent, the additive may be at least one element selected among Mg, Ca, and Sr.

The silicon nitride-melilite composite sintered body of the embodiment contains the favorable additive for the enhanced sinterability. This arrangement assures the more stable production of the silicon nitride-melilite composite sintered body having the sufficiently high Young's modulus of not lower than 200 GPa and the average thermal expansion coefficient arbitrarily adjustable in the range of 2 to 6 ppm/K at the temperatures of 23°C to 150°C.

In the silicon nitride-melilite composite sintered body of the above embodiment, the additive may be Sr.

The silicon nitride-melilite composite sintered body of the embodiment contains the most favorable additive for the further enhanced sinterability. This arrangement assures the more stable production of the silicon nitride-melilite composite sintered body having the sufficiently high Young's modulus of not lower than 200 GPa and the average thermal expansion coefficient arbitrarily adjustable in the range of 2 to 6 ppm/K at the temperatures of 23°C to 150°C.

The group 2 element Mg, Ca, or Sr added in the form of an oxide (for example, SrO) tends to react with the water content and produce a hydroxide (for example, $Sr(OH)_2$) in the manufacturing process. The group 2 element Mg, Ca, or Sr is accordingly added in the form of a carbonate (for example, $SrCO_3$). The thermal stability of the carbonates of these group 2 elements increases in the order of Mg < Ca < Sr. This proves that Sr is especially preferable for the stable production of the silicon nitride-melilite composite sintered body.

In another preferable embodiment, the silicon nitride-melilite composite sintered body according to the first aspect of the invention contains Si in a range of 45 to 83 mol% in $Si_3N_4$ equivalent, Me in a range of 15 to 49 mol% in oxide equivalent, and at least one element selected among La, Ce, and Pr as an additive in a range of 0.3 to 12 mol% in oxide equivalent.

The silicon nitride-melilite composite sintered body of the embodiment has the desirable composition for the enhanced sinterability. The adequate content of at least one element selected among La, Ce, and Pr as the additive allows for production of the composite sintered body by sintering at ordinary pressure, as well as by sintering under a pressuring condition, for example, gas pressure sintering, hot isostatic pressing, or hot pressing. This arrangement accordingly has the industrial advantages, for example, the reduced restrictions on the dimensions and the shape of the resulting composite sintered body and the lowered manufacturing cost by large scale production. This arrangement also assures the stable production of the silicon nitride-melilite composite sintered body having the sufficiently high Young's modulus of not lower than 200 GPa and the average thermal expansion coefficient arbitrarily adjustable in the range of 2 to 6 ppm/K at the temperatures of 23°C to 150°C.

In one preferable embodiment of the silicon nitride-melilite composite sintered body according to the first aspect of the invention, Me is a group 3 element.

The silicon nitride-melilite composite sintered body of the embodiment has the favorable metal element Me.

In one preferable application of the silicon nitride-melilite composite sintered body of the above embodiment, Me is Y.

The silicon nitride-melilite composite sintered body of this application has the most favorable metal element Me that combines with silicon nitride to generate the melilite. Yttrium is readily combined with silicon nitride to form the melilite and is readily available. This arrangement assures the easy and stable production of the silicon nitride-melilite composite sintered body having the sufficiently high Young's modulus of not lower than 200 GPa and the average thermal expansion coefficient arbitrarily adjustable in the range of 2 to 6 ppm/K at the temperatures of 23°C to 150°C, while effectively reducing the manufacturing cost.

In another preferable embodiment of the silicon nitride-melilite composite sintered body according to the first aspect of the invention, a diffraction intensity '*a*' of a main peak of the silicon nitride and a diffraction intensity 'b' of a main peak of the melilite observed by X-ray diffractometry of the silicon nitride-melilite composite sintered body satisfy a relation of:

$$50 \leq [b / (a+b)] \times 100 \leq 98.$$

The diffraction intensity '*a*' of the main peak of the silicon nitride represents a diffraction intensity of a highest peak among all the peaks of the silicon nitride. The diffraction intensity '*b*' of the main peak of the melilite represents a diffraction intensity of a highest peak among all the peaks of the melilite.

This arrangement assures the stable production of the silicon nitride-melilite composite sintered body having the sufficiently high Young's modulus of not lower than 200 GPa and the average thermal expansion coefficient arbitrarily adjustable in the range of 2 to 6 ppm/K at the temperatures of 23°C to 150°C.

In one preferable embodiment of the invention, the silicon nitride-melilite composite sintered body has the average thermal expansion coefficient in the range of 2 to 6 ppm/K at the temperatures of 23°C to 150°C.

This arrangement assures the production of the silicon nitride-melilite composite sintered body having the average thermal expansion coefficient arbitrarily adjustable in the range of 2 to 6 ppm/K at the temperatures of 23°C to 150°C.

In another preferable embodiment of the invention, the silicon nitride-melilite composite sintered body has the Young's modulus of not lower than 200 GPa.

This arrangement assures the production of the silicon nitride-melilite composite sintered body having the sufficiently high Young's modulus of not lower than 200 GPa.

In the silicon nitride-melilite composite sintered body according to the first aspect of the invention having a fixed composition, the strength of the material and the Young's modulus may be increased by regulation of the microstructure.

The main factors affecting the microstructure include the particle diameter of the material, the amount of the additive, the amount of the material oxygen, and the sintering temperature. Figs. 13A through 13D are electron micrographs at a 3000-fold magnification by SEM imaging of silicon nitride-melilite composite sintered bodies having a fixed composition but different microstructures. The values under the respective electron micrographs show the bending strengths of the respective composite sintered bodies measured at room temperature (23°C) in conformity with JIS R 1601. As clearly shown in these electron micrographs, the fineness of the microstructures of the composite sintered bodies increases in the order of Fig. 13A, Fig. 13B, Fig. 13C, and Fig. 13D. The bending strength of the composite sintered bodies also increases in this order, that is, with an increase in fineness of the microstructures of the composite sintered bodies.

The silicon nitride-melilite composite sintered body according to the first aspect of the invention may have an amount of surplus oxygen in a range of 2 to 16 mol% in $SiO_2$ equivalent.

The amount of surplus oxygen represents a residual amount of oxygen calculated by subtracting an amount of oxygen belonging to the components other than Si from the total amount of oxygen contained in the whole composite sintered body. The surplus oxygen is mainly from oxygen included in the silicon nitride and oxygen included in the additives and may be additionally from oxygen adsorbed in the manufacturing process or from oxygen of $SiO_2$ added as an oxygen source. In this embodiment, the amount of surplus oxygen is converted into $SiO_2$ equivalent. The amount of surplus oxygen of lower than 2 mol% in $SiO_2$ equivalent causes the poor sinterability. The amount of surplus oxygen of higher than 16 mol% in $SiO_2$ equivalent, on the other hand, causes aggregation of the melilite and the silicon nitride. Such aggregates of the melilite and the silicon nitride may work as the origin of the fracture, so that the composite sintered body having the excessive amount of surplus oxygen has the undesirably lowered mechanical strength. The preferable range of the amount of surplus oxygen is 2 to 14 mol%.

Other crystalline phases but the silicon nitride crystalline phases and the melilite crystalline phases may be generated according to the content of the additive or according to the amount of surplus oxygen. For example, an excessive amount of SrO generates crystalline phases of, for example, $SrSiO_3$ and $Sr_2SiO_4$. An excessive amount of surplus oxygen generates crystalline phases of, for example, $Y_{20}Si_{12}O_{48}N_4$. Other examples of crystalline phases of, for example, $Y_2SiO_5$, $Y_2Si_2O_7$, $Y_4Si_2O_7N_2$ (J phases), $YSiO_2N$ (K phases), and $Y_{10}Si_7O_{23}N_4$ (H phases) may also be generated according to the sintering conditions or according to some influence factors in the manufacturing process.

The device according to the fourth aspect of the invention may be a probe card having a substrate as the member.

The probe card is used to inspect integrated circuits formed on semiconductor wafers with the high reliability. The silicon nitride-melilite composite sintered body of the invention is the more favorable material than the conventional ceramic material made of a single component (for example, alumina, aluminum nitride, silicon carbide, or silicon nitride). The silicon nitride-melilite composite sintered body of the invention has the thermal expansion coefficient arbitrarily adjustable in some adequate range to be sufficiently closer to the required level of thermal expansion characteristic for the probe card used for inspection of semiconductor wafers. The semiconductor inspection device according to the fourth aspect of the invention utilizing the silicon nitride-melilite composite sintered body of the invention thus assures inspection of semiconductor wafers with the high reliability.

## Claims

1. A silicon nitride-melilite composite sintered body comprising:

   silicon nitride crystalline phases;
   melilite crystalline phases of $Me_2Si_3O_3N_4$, where "Me" denotes a metal element combining with silicon nitride to generate a melilite; and
   grain boundary phases;
   and an additive selected among:

      (A): group 2 elements, or
      (B): La, Ce, and Pr

   wherein a ratio of the melilite crystalline phases is not less than 20 area% on a cross section of the silicon nitride-melilite composite sintered body;
   wherein the silicon nitride-mellilite composite sintered body contains Al in a range of 2 to 10 mol% in oxide equivalent;
   and wherein:

      in the case of (A) using at least one element selected among group 2 elements as the additive, the resulting silicon nitride-melilite composite sintered body contains Si in a range of 41 to 79 mol% in $Si_3N_4$ equivalent, Me in a range of 13 to 46 mol% in oxide equivalent, and the group 2 element in a range of 5 to 20 mol% in oxide equivalent; or
      in the case of (B) using at least one element selected among La, Ce, and Pr as the additive, the resulting silicon nitride-melilite composite sintered body contains Si in a range of 45 to 83 mol% in $Si_3N_4$ equivalent, Me in a range of 15 to 49 mol% in oxide equivalent, and the at least one element selected among La, Ce, and Pr in a range of 0.3 to 12 mol% in oxide equivalent.

2. The silicon nitride-melilite composite sintered body in accordance with claim 1, the silicon nitride-melilite composite sintered body has a water absorption rate of not higher than 1.5%,
   wherein a sum of the ratio of the melilite crystalline phases and a ratio of the silicon nitride crystalline phases is not less than 80 area% on the cross section of the silicon nitride-melilite composite sintered body.

3. The silicon nitride-melilite composite sintered body in accordance with claim 1 or 2, wherein the additive is at least one element selected among Mg, Ca, and Sr.

4. The silicon nitride-melilite composite sintered body according to any one of claims 1 to 3, wherein Me is a group 3 element, preferably Y (yttrium).

5. The silicon nitride-melilite composite sintered body according to any one of claims 1 to 4,
   wherein a diffraction intensity '*a*' of a main peak of the silicon nitride and a diffraction intensity 'b' of a main peak of the melilite observed by X-ray diffractometry of the silicon nitride-melilite composite sintered body satisfy a relation of:

$$50 \leq [\underline{b} /(a+b)] \times 100 \leq 98.$$

6. The silicon nitride-melilite composite sintered body according to any one of claims 1 to 5,
   wherein the silicon nitride-melilite composite sintered body has at least one of: (a) an average thermal expansion coefficient in a range of 2 to 6 ppm/K at temperatures of 23 to 150°C; or (b) a Young's modulus measured at room temperature (23°C) of not lower than 200 GPa.

7. The silicon nitride-melilite composite sintered body according to any one of claims 1 to 6, wherein its theoretical density ratio as herein defined is at least 98%.

8. A substrate comprising a silicon nitride-melilite composite sintered body; or a member attached to a circuit board with an electronic part mounted thereon, the member comprising a silicon nitride-melilite composite sintered body, wherein
the silicon nitride-melilite composite sintered body is in accordance with any one of claims 1 to 7.

9. A device used for inspection or production of semiconductor, the device having a member, or the device comprising a probe card having a member, the member comprising a silicon nitride-melilite composite sintered body in accordance with any one of claims 1 to 7.

10. A probe card, the probe card having a member, the member comprising a silicon nitride-melilite composite sintered body in accordance with any one of claims 1 to 7.

**Patentansprüche**

1. Gesinterter Siliciumnitrid-Melilith-Verbundstoffkörper, umfassend:

kristalline Siliciumnitridphasen;
kristalline Melilithphasen von $Me_2Si_3O_3N_4$, wobei "Me" ein Metallelement bezeichnet, das sich mit Silicium verbindet, um ein Melilith zu erzeugen; und
Korngrenzenphasen;
und ein Additiv gewählt aus:

(A) : Elementen der Gruppe 2 oder
(B) : La, Ce und Pr,

wobei ein Verhältnis der kristallinen Melilithphasen an einem Querschnitt des gesinterten Siliciumnitrid-Melilith-Verbundstoffkörpers nicht kleiner als 20 Flächenprozent ist;
wobei der gesinterte Siliciumnitrid-Melilith-Verbundstoffkörper Al in einem Bereich von 2 bis 10 Mol-% in Oxidäquivalent enthält;
und wobei:

in dem Fall (A) des Verwendens mindestens eines Elements gewählt aus Elementen der Gruppe 2 als Additiv der resultierende gesinterte Siliciumnitrid-Melilith-Verbundstoffkörper Si in einem Bereich von 41 bis 79 Mol-% in $Si_3N_4$ -Äquivalent, Me in einem Bereich von 13 bis 46 Mol-% in Oxidäquivalent und das Element der Gruppe 2 in einem Bereich von 5 bis 20 Mol-% in Oxidäquivalent enthält; oder
in dem Fall (B) des Verwendens mindestens eines Elements gewählt aus La, Ce und Pr als Additiv der resultierende gesinterte Siliciumnitrid-Melilith-Verbundstoffkörper Si in einem Bereich von 45 bis 83 Mol-% in $Si_3N_4$-Äquivalent, Me in einem Bereich von 15 bis 49 Mol-% in Oxidäquivalent und das mindestens eine Element gewählt aus La, Ce und Pr in einem Bereich von 0,3 bis 12 Mol-% in Oxidäquivalent enthält.

2. Gesinterter Siliciumnitrid-Melilith-Verbundstoffkörper nach Anspruch 1, der gesinterte Siliciumnitrid-Melilith-Verbundstoffkörper weist eine Wasserabsorptionsrate von nicht mehr als 1,5% auf,
wobei eine Summe des Verhältnisses der kristallinen Melilithphasen und eines Verhältnisses der kristallinen Siliciumnitridphasen an dem Querschnitt des gesinterten Siliciumnitrid-Melilith-Verbundstoffkörpers nicht kleiner als 80 Flächen-% ist.

3. Gesinterter Siliciumnitrid-Melilith-Verbundstoffkörper nach Anspruch 1 oder 2, wobei das Additiv mindestens ein Element gewählt aus Mg, Ca und Sr ist.

4. Gesinterter Siliciumnitrid-Melilith-Verbundstoffkörper nach einem der Ansprüche 1 bis 3, wobei Me ein Element der Gruppe 3, bevorzugt Y (Yttrium), ist.

5. Gesinterter Siliciumnitrid-Melilith-Verbundstoffkörper nach einem der Ansprüche 1 bis 4, wobei eine Diffraktionsintensität 'a' einer Hauptspitze des Siliciumnitrids und eine Diffraktionsintensität 'b' einer Hauptspitze des Meliliths, die durch Röntgendiffraktometrie des gesinterten Siliciumnitrid-Melilith-Verbundstoffkörpers feststellt werden, eine Beziehung:

$$50 \leq [b/(a+b)] \times 100 \leq 98$$

erfüllen.

6. Gesinterter Siliciumnitrid-Melilith-Verbundstoffkörper nach einem der Ansprüche 1 bis 5, wobei der gesinterte Siliciumnitrid-Melilith-Verbundstoffkörper mindestens eines von: einem mittleren Wärmeausdehnungskoeffizienten in einem Bereich von 2 bis 6 ppm/K bei einer Temperatur von 23 bis 150°C; oder (b) einem bei Raumtemperatur (23°C) gemessenen E-Modul von nicht weniger als 200 GPa aufweist.

7. Gesinterter Siliciumnitrid-Melilith-Verbundstoffkörper nach einem der Ansprüche 1 bis 6, wobei sein theoretisches Dichteverhältnis wie hierin festgelegt mindestens 98% beträgt.

8. Substrat, welches einen gesinterten Siliciumnitrid-Melilith-Verbundstoffkörper umfasst; oder ein an einer Leiterplatte mit einem daran montierten Elektronikbauteil angebrachtes Element, wobei das Element einen gesinterten Siliciumnitrid-Melilith-Verbundstoffkörper umfasst, wobei
der gesinterte Siliciumnitrid-Melilith-Verbundstoffkörper nach einem der Ansprüche 1 bis 7 ist.

9. Vorrichtung, die zur Prüfung oder Herstellung eines Halbleiters verwendet wird, wobei die Vorrichtung ein Element aufweist oder die Vorrichtung eine Probecard mit einem Element umfasst, wobei das Element einen gesinterten Siliciumnitrid-Melilith-Verbundstoffkörper nach einem der Ansprüche 1 bis 7 umfasst

10. Probecoard, wobei die Probecard ein Element aufweist, wobei das Element einen gesinterten Siliciumnitrid-Melilith-Verbundstoffkörper nach einem der Ansprüche 1 bis 7 umfasst.

**Revendications**

1. Corps fritté composite de nitrure de silicium-mélilite comprenant :

des phases cristallines de nitrure de silicium ;
des phases cristallines de mélilite de $Me_2Si_3O_3N_4$ où « Me » représente un élément métallique se combinant avec le nitrure de silicium pour produire une mélilite ; et
des phases de joint de grain ;
et un additif choisi parmi :

(A) : les éléments du groupe 2, ou
(B) : La, Ce et Pr

dans lequel le rapport des phases cristallines de mélilite n'est pas inférieur à 20 % en surface sur une section transversale du corps fritté composite de nitrure de silicium-mélilite ;
dans lequel le corps fritté composite de nitrure de silicium-mélilite contient de l'Al dans une plage de 2 à 10 % en moles en équivalents d'oxyde ;
et dans lequel :

dans le cas de (A) utilisant au moins un élément choisi parmi les éléments du groupe 2 en tant qu'additif, le corps fritté composite de nitrure de silicium-mélilite résultant contient du Si dans la plage de 41 à 79 % en moles en équivalent de $Si_3N$, du Me dans la plage de 13 à 46 % en moles en équivalent d'oxyde, et l'élément du groupe 2 dans la plage allant de 5 à 20 % en moles en équivalent d'oxyde ; ou
dans le cas de (B) utilisant au moins un élément choisi parmi La, Ce et Pr en tant qu'additif, le corps fritté composite de nitrure de silicium-mélilite résultant contient du Si dans une plage allant de 45 à 83 % en moles en équivalent de $Si_3N$, du Me dans la plage de 15 à 49 % en moles en équivalent d'oxyde, et l'au moins un élément choisi parmi La, Ce et Pr dans une plage de 0,3 à 12 % en moles en équivalent d'oxyde.

2. Corps fritté composite de nitrure de silicium-mélilite selon la revendication 1, dans lequel le corps fritté composite de nitrure de silicium-mélilite a un taux d'absorption d'eau non supérieur à 1,5 %,
dans lequel la somme du rapport des phases cristallines de mélilite et du rapport des phases cristallines de nitrure de silicium n'est pas inférieure à 80 % en surface sur la section transversale du corps fritté composite de nitrure de silicium-mélilite.

**3.** Corps fritté composite de nitrure de silicium-mélilite selon la revendication 1 ou 2, dans lequel l'additif est au moins un élément choisi parmi Mg, Ca et Sr.

**4.** Corps fritté composite de nitrure de silicium-mélilite selon l'une quelconque des revendications 1 à 3, dans lequel Me est un élément du groupe 3, de préférence Y (yttrium).

**5.** Corps fritté composite de nitrure de silicium-mélilite selon l'une quelconque des revendications 1 à 4, dans lequel une intensité de diffraction 'a' d'un pic principal du nitrure de silicium et une intensité de diffraction 'b' d'un pic principal de la mélilite observées par diffractométrie des rayons X du corps fritté composite de nitrure de silicium-mélilite satisfont à la relation :

$$50 \leq [b/(a+b)] \times 100 \leq 98.$$

**6.** Corps fritté composite de nitrure de silicium-mélilite selon l'une quelconque des revendications 1 à 5, dans lequel le corps fritté composite de nitrure de silicium-mélilite a au moins un de : (a) un coefficient d'expansion thermique moyen dans une plage de 2 à 6 ppm/K à des températures de 23 à 150 °C ; ou (b) un module de Young mesuré à température ambiante (23 °C) non inférieur à 200 GPa.

**7.** Corps fritté composite de nitrure de silicium-mélilite selon l'une quelconque des revendications 1 à 6, dans lequel son rapport de densité théorique tel que défini ici est d'au moins 98 %.

**8.** Substrat comprenant un corps fritté composite de nitrure de silicium-mélilite ; ou un élément attaché à une carte imprimée avec une partie électronique montée sur celui-ci, l'élément comprenant un corps fritté composite de nitrure de silicium-mélilite, dans lequel
le corps fritté composite de nitrure de silicium-mélilite est selon l'une quelconque des revendications 1 à 7.

**9.** Dispositif utilisé pour l'inspection ou la production d'un semiconducteur, le dispositif ayant un élément, ou le dispositif comprenant une carte sonde ayant un élément, l'élément comprenant un corps fritté composite de nitrure de silicium-mélilite selon l'une quelconque des revendications 1 à 7.

**10.** Carte sonde, la carte sonde ayant un élément, l'élément comprenant un corps fritté composite de nitrure de silicium-mélilite selon l'une quelconque des revendications 1 à 7.

Fig.1A

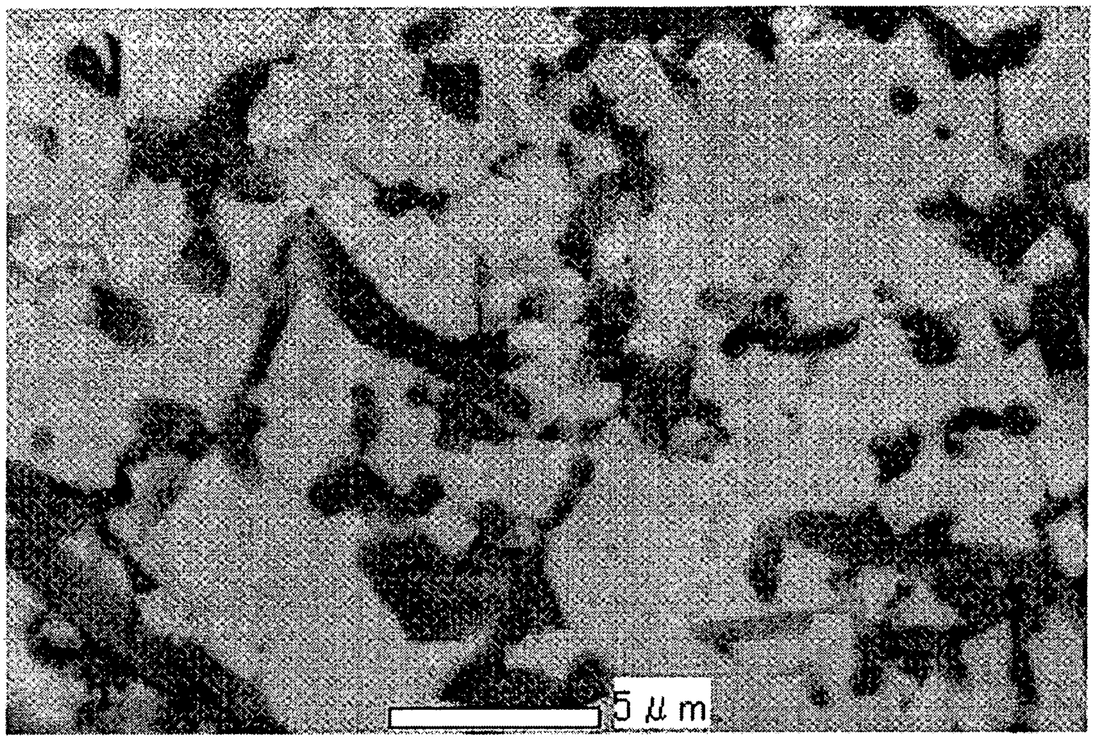


Fig.1B

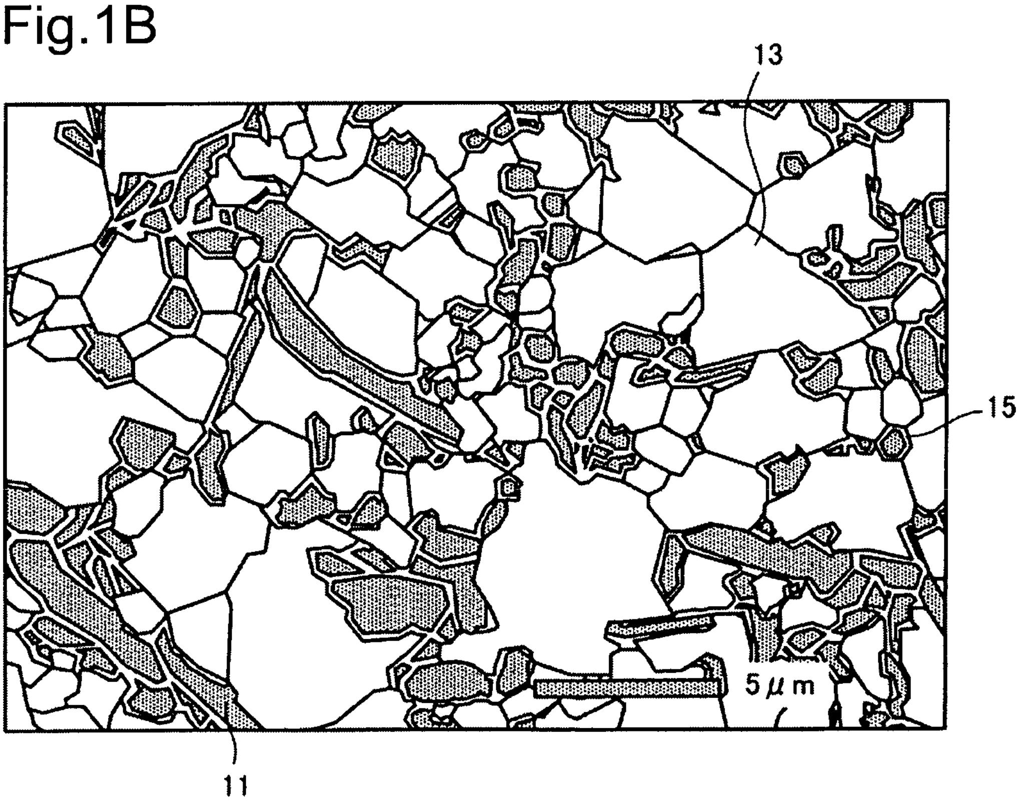

Fig.2

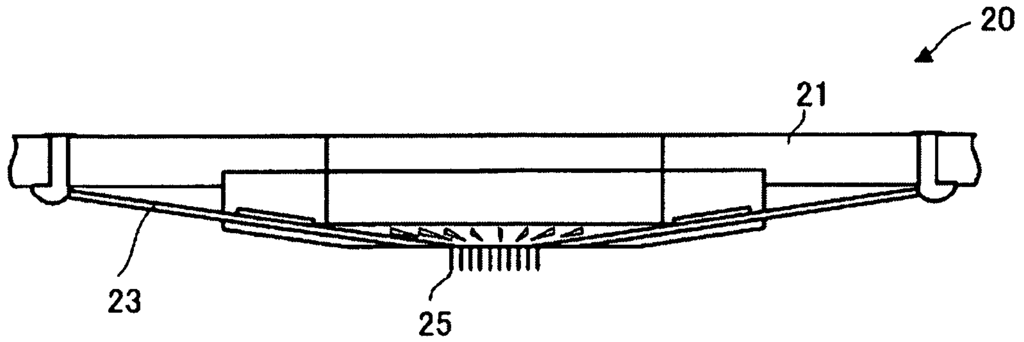


Fig.3

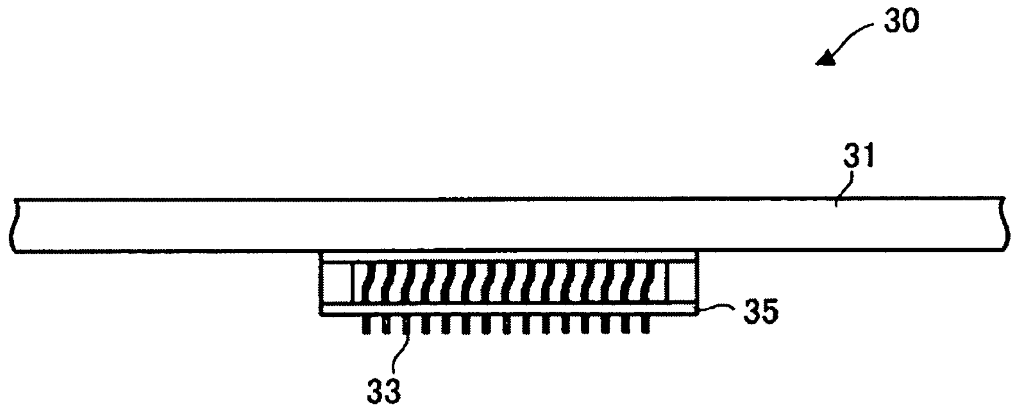


Fig.4

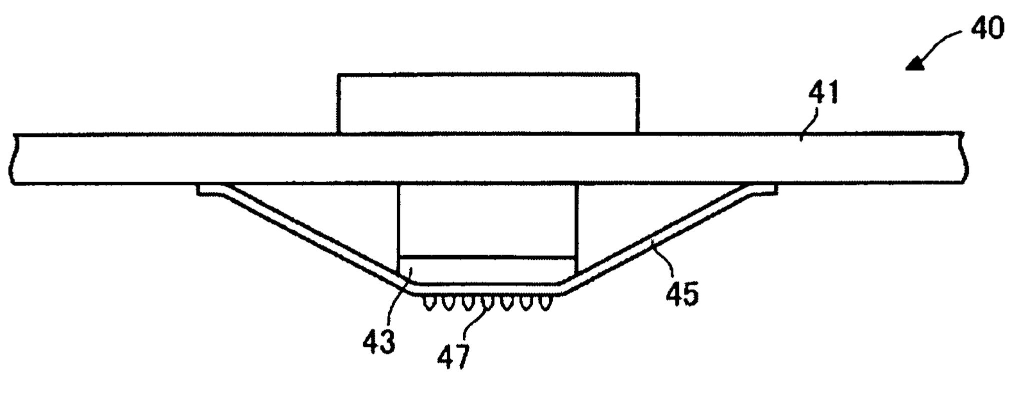

Fig.5

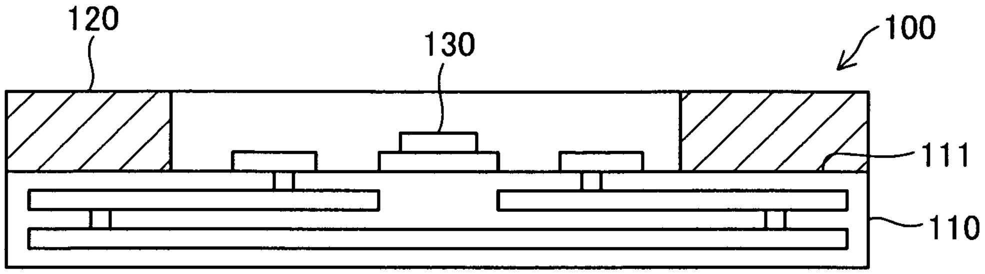


Fig.6

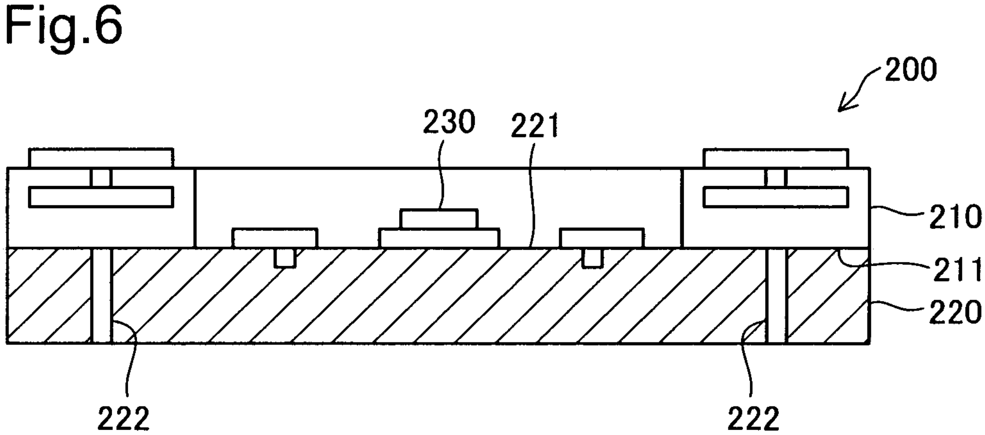


Fig.7

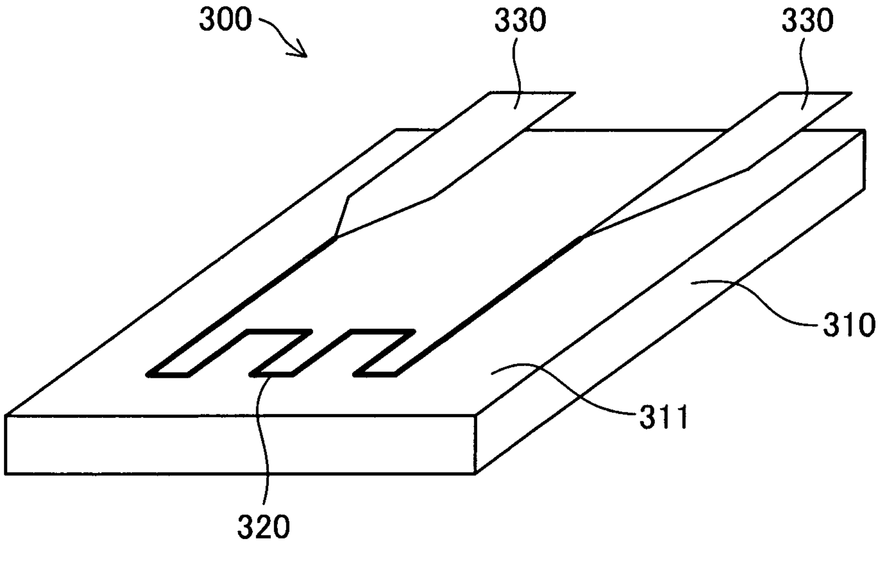

Fig.8

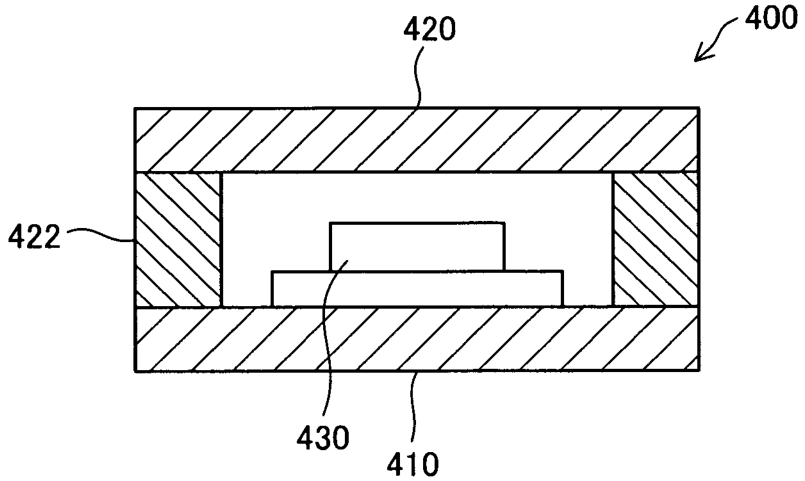


Fig.9

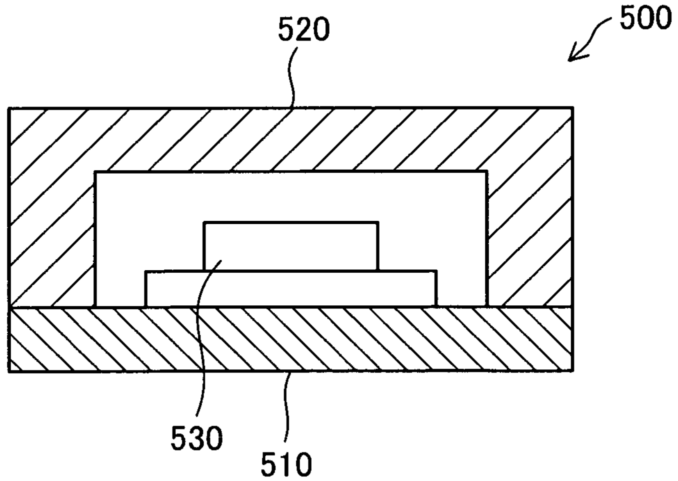

Fig.10

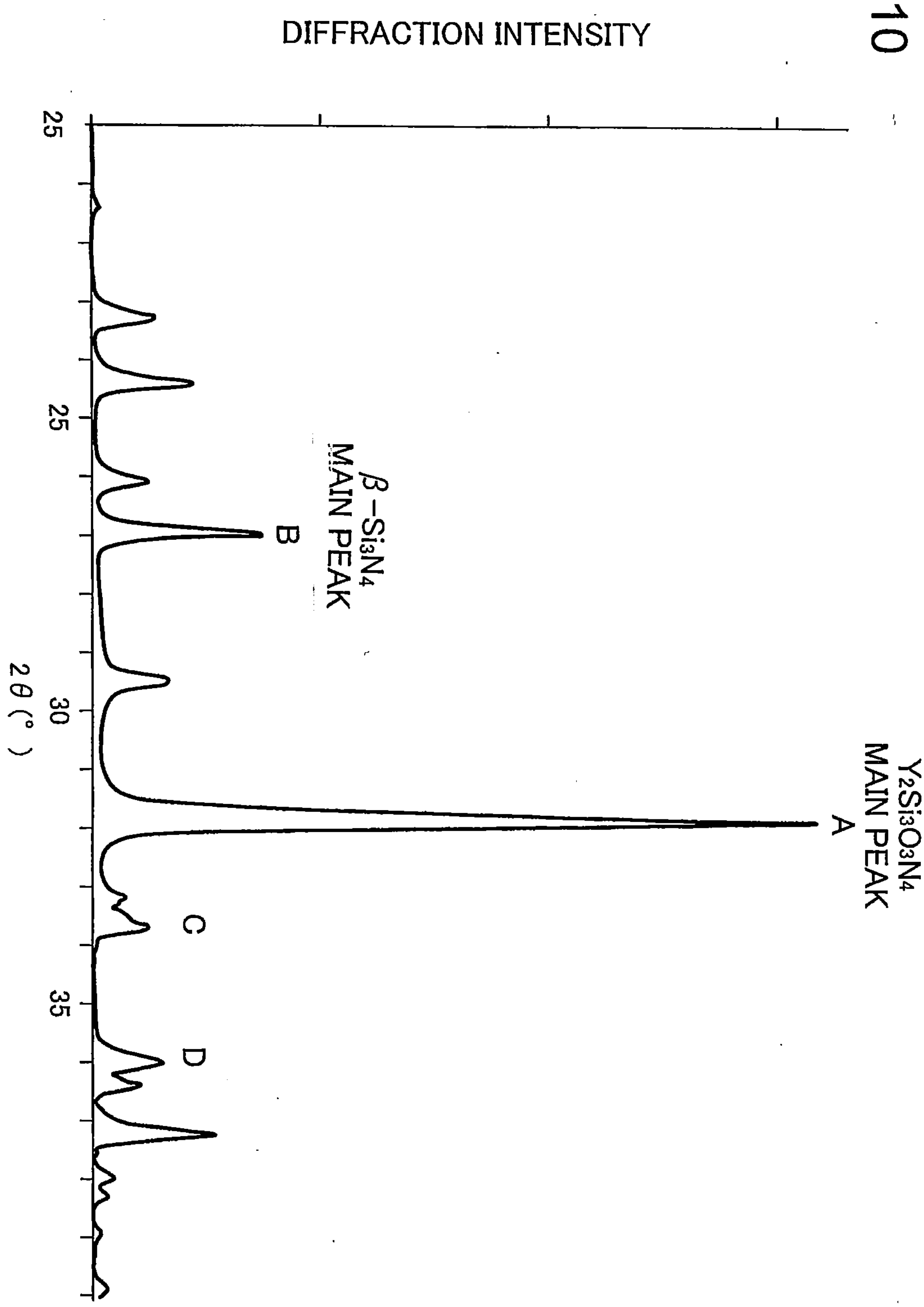
DIFFRACTION INTENSITY
25
25
30
35
2θ (° )
$\beta$-$Si_3N_4$
MAIN PEAK
B
$Y_2Si_3O_3N_4$
MAIN PEAK
A
C
D

Fig.11

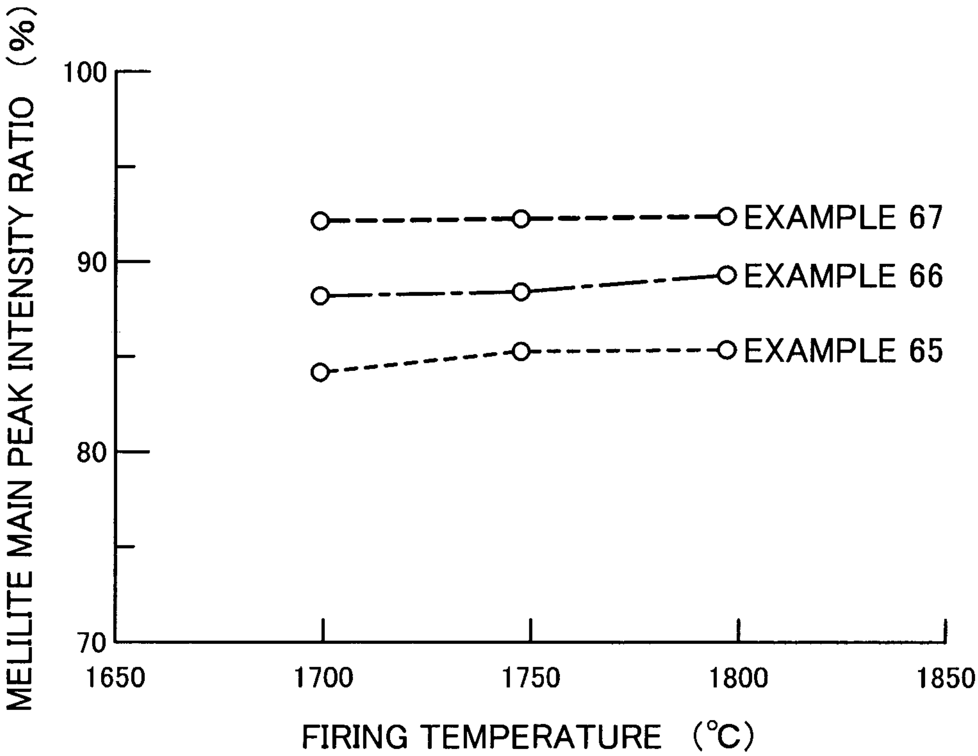
MELILITE MAIN PEAK INTENSITY RATIO (%)
100
90
80
70
1650
1700
1750
1800
1850
FIRING TEMPERATURE (°C)
EXAMPLE 67
EXAMPLE 66
EXAMPLE 65

Fig.12

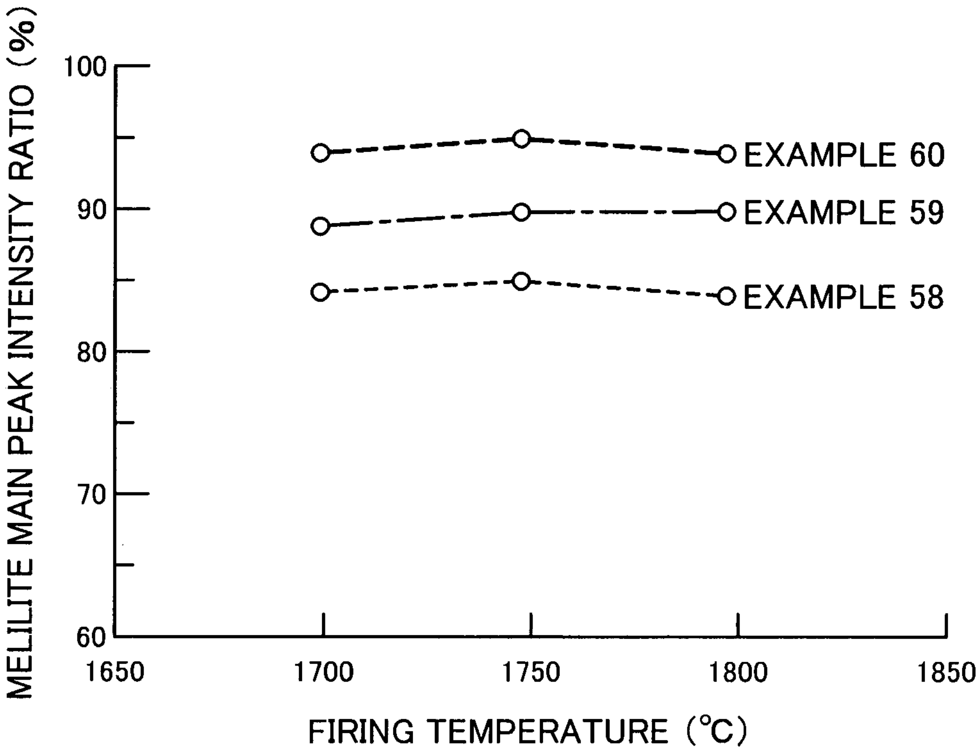
MELILITE MAIN PEAK INTENSITY RATIO (%)
100
90
80
70
60
1650
1700
1750
1800
1850
FIRING TEMPERATURE (°C)
EXAMPLE 60
EXAMPLE 59
EXAMPLE 58

Fig.13A

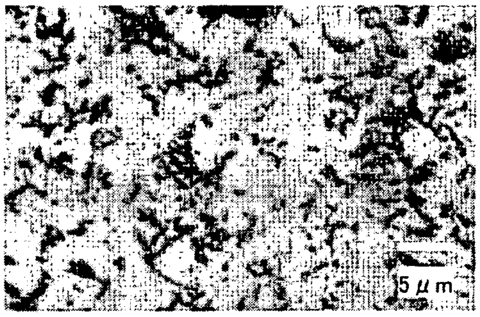


500MPa

Fig.13B

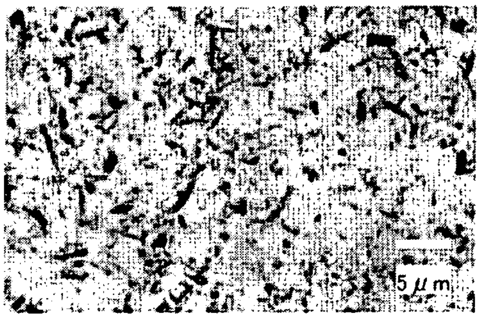


530MPa

Fig.13C

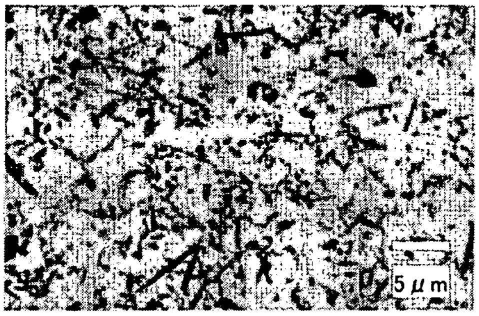


630MPa

Fig.13D

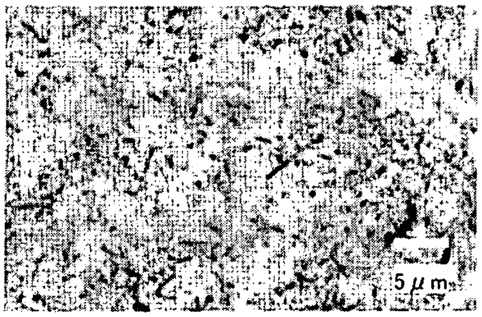


640MPa

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6294244 B1
- JP 2002128567 A
- US 5114888 A
- JP 6027029 A
- JP 2009298688 A